# EUROPEAN PATENT APPLICATION

(11) **EP 4 489 063 A1**
(43) Date of publication of application: **08.01.2025**
(21) Application number: 24185003.1
(22) Date of filing: 27.06.2024
(51) Int. Cl.: H01L 21/677

(54) **SUBSTRATE TREATMENT SYSTEM**

(30) Priority: 30.06.2023 JP 2023108279
(71) Applicant: SCREEN Holdings Co., Ltd., Kyoto-shi, Kyoto 602-8585 (JP)
(72) Inventor: IWASAKI, Akihiro, Kyoto-shi, 602-8585 (JP); TOMITA, Tsuyoshi, Kyoto-shi, 602-8585 (JP); TANIGUCHI, Shinichi, Kyoto-shi, 602-8585 (JP)
(74) Representative: Kilian Kilian & Partner mbB

(57) **Abstract**

A substrate treatment system includes a batch treatment device, a single-wafer treatment device, and an interface device that connects the batch treatment device and the single-wafer treatment device. The batch treatment device extends to a rear side. The single-wafer treatment device faces the batch treatment device to be aligned in a width direction orthogonal to the rear side. The interface device is disposed adjacent to one end side of each of the batch treatment device and the single-wafer treatment device to extend in the width direction. The batch substrate transport region of the batch treatment device is disposed adjacent to a transfer block and a treatment block on a side where the single-wafer treatment device is disposed. The interface device includes a posture turning region and a relay region. The posture turning region is disposed on an opposite side to the treatment block via the transfer block.

## Description

### BACKGROUND

### Technical Field

The present invention relates to a substrate treatment system that performs treatment on a substrate. Examples of substrates include a semiconductor substrate, a substrate for a flat panel display (FPD), a glass substrate for a photomask, a substrate for an optical disc, a substrate for a magnetic disk, a ceramic substrate, and a substrate for a solar cell. Examples of FPDs include a liquid crystal display and an organic electroluminescence (EL) display device.

### Related Art

In a conventional substrate treatment system, a loading device, a second interface device, a batch treatment device, a first interface device, a single-wafer treatment device, and an unloading device are arranged in this order in a U shape (refer to, for example, JP 2021-064652 A).

Here, a direction in which the loading device, the second interface device, and the batch treatment device are arranged will be referred to as a front-rear direction. A horizontal direction orthogonal to the front-rear direction will be referred to as a width direction. In this case, in the substrate treatment system described above, the loading device, the second interface device, and the batch treatment device are arranged in a line on the rear side in this order. The unloading device and the single-wafer treatment device are arranged in a line on the rear side in this order. The first interface device extends to the right side from the batch treatment device to the single-wafer treatment device. That is, the single-wafer treatment device is provided on the right side of the batch treatment device.

### SUMMARY

The conventional substrate treatment system has the following problems. As in the substrate treatment system described above, for example, it is assumed that the first interface device (interface device) is provided on the rear side of the batch treatment device and on the rear side of the single-wafer treatment device. In this case, when the batch treatment device is lengthened in the front-rear direction as desired by a user, for example, it is necessary to change a transport path of the first interface device or the single-wafer treatment device. This change may be troublesome, and this may restrict the change in configurations of the batch treatment device and the single-wafer treatment device.

The present invention has been made in view of such circumstances, and an object thereof is to provide a substrate treatment system allowing configurations of a batch treatment device and a single-wafer treatment device to be changed freely.

In order to achieve such an object, the present invention has the following configuration. That is, according to the present invention, there is provided a substrate treatment system including a batch treatment device that collectively performs treatment on a plurality of substrates; a single-wafer treatment device that performs treatment on the plurality of substrates one by one; and an interface device that connects the batch treatment device and the single-wafer treatment device, in which the batch treatment device extends in a first horizontal direction, the single-wafer treatment device is disposed to face the batch treatment device such that the single-wafer treatment device is aligned in a second horizontal direction orthogonal to the first horizontal direction, the interface device is disposed to be adjacent to one end side of each of the batch treatment device and the single-wafer treatment device and to extend in the second horizontal direction, the batch treatment device includes a first carrier placement shelf on which a carrier for storing the plurality of substrates at a predetermined interval in a horizontal posture is placed, a transfer block that is adjacent to the first carrier placement shelf, a batch treatment block that is adjacent to the transfer block and extends in the first horizontal direction, and a batch substrate transport region that is disposed adjacent to the transfer block and the batch treatment block on a side where the single-wafer treatment device is disposed and that has one end side extending to the interface device and the other end side extending in the first horizontal direction, the transfer block includes a substrate handling mechanism and a first posture turning mechanism, the substrate handling mechanism is configured to take out the plurality of substrates in a horizontal posture from the carrier placed on the first carrier placement shelf, the first posture turning mechanism includes a first posture turning unit that turns the plurality of substrates received from the substrate handling mechanism from a horizontal posture to a vertical posture, and a vertical holder that holds the plurality of substrates turned into the vertical posture by the first posture turning unit, the batch treatment block includes a plurality of batch treatment tanks arranged side by side in the first horizontal direction, each of the plurality of batch treatment tanks storing a treatment solution for immersing the plurality of substrates, the batch substrate transport region includes a first batch transport mechanism that transports the plurality of substrates in a vertical posture between the plurality of batch treatment tanks, the vertical holder, and the interface device, the interface device includes a posture turning region that is disposed on an opposite side to the batch treatment block via the transfer block and a relay region that is adjacent to the posture turning region and extends in the second horizontal direction, the posture turning region includes a second posture turning mechanism that turns the plurality of substrates subjected to treatment in the batch treatment device from a vertical posture to a horizontal posture, the relay region includes a relay substrate transport mechanism that transports the plurality of substrates turned into the horizontal posture by the second posture turning mechanism to the single-wafer treatment device, the single-wafer treatment device includes a second carrier placement shelf on which the carrier is placed, and a single-wafer treatment block that is adjacent to the second carrier placement shelf, the single-wafer treatment block includes a plurality of single-wafer treatment chambers that perform predetermined treatment on the plurality of substrates subjected to treatment in the batch treatment device one by one, and a horizontal substrate transport robot that receives the substrate transported by the relay substrate transport mechanism and transports the received substrate to one of the plurality of single-wafer treatment chambers, and the horizontal substrate transport robot is configured to store the substrate subjected to treatment in one of the plurality of single-wafer treatment chambers in the carrier placed on the second carrier placement shelf.

According to the substrate treatment system of the present invention, the posture turning region of the interface device is provided on the opposite side to the treatment block having the batch treatment tank via the transfer block of the batch treatment device. For example, it is assumed that a length of the batch treatment device may be changed in the first horizontal direction in which the batch treatment device extends as the number of batch treatment tanks of the batch treatment device is increased or decreased. Even in this case, it is not necessary to change at least the configurations of the transfer block of the batch treatment device and the interface device. Therefore, it is possible to freely change the configurations of the batch treatment device and the single-wafer treatment device.

In addition, since the posture turning region is provided on the opposite side to the treatment block via the transfer block, it is possible to prevent the relay region of the interface device from intersecting the batch substrate transport region in a plan view. Therefore, a configuration is prevented from being complicated. In addition, a single-wafer treatment device is provided on the opposite side to the transfer block via the batch substrate transport region. Therefore, an extent to which the interface device blocks one side of the transfer block in a plan view is able to be curbed. In addition, a wide maintenance region can be secured on the opposite side to the batch substrate transport region via the batch treatment tank.

Further, in the above-described substrate treatment system, the second posture turning mechanism preferably includes a second posture turning unit that turns the plurality of substrates from a vertical posture to a horizontal posture, and a standby tank that is provided between the transfer block and the second posture turning unit and stores an immersion liquid in which the plurality of substrates are immersed in the vertical posture.

The second posture turning mechanism can cause a plurality of substrates to be on standby in a vertical posture while immersing the plurality of substrates in an immersion liquid stored in the standby tank.

Further, in the substrate treatment system described above, preferably, the second posture turning mechanism further includes a second batch transport mechanism, the second batch transport mechanism includes a guide rail provided on an opposite side to the batch substrate transport region via the standby tank, the second batch transport mechanism transports the plurality of substrates from the standby tank to the second posture turning unit in a vertical posture along the guide rail, and the first batch transport mechanism transports the plurality of substrates in the vertical posture between the plurality of batch treatment tanks, the vertical holder, and the standby tank.

The guide rail is disposed such that the standby tank is disposed between the guide rail and the batch substrate transport region. Therefore, it is possible to prevent the second batch transport mechanism that transports the substrate along the guide rail from interfering with the substrate transport from the second posture turning unit to the relay substrate transport mechanism by crossing between the second posture turning unit and the relay substrate transport mechanism.

Further, in the substrate treatment system described above, preferably, the second batch transport mechanism includes a pair of chucks in which a plurality of pairs of holding grooves and a plurality of pairs of passage grooves are alternately disposed, and in a case where a treatment substrate group in which a plurality of substrates and another plurality of substrates are alternately disposed is immersed in the immersion liquid in the standby tank, the second batch transport mechanism takes out the plurality of substrates from the treatment substrate group by using the pair of chucks and transports the plurality of taken-out substrates to the second posture turning unit.

The second batch transport mechanism can take out a plurality of substrates (first substrate group) from a treatment substrate group in which a plurality of substrates (first substrate group) and another plurality of substrates (second substrate group) are alternately disposed. The plurality of taken-out substrates (first substrate group) are turned into a horizontal posture by the second posture turning unit. On the other hand, the other plurality of substrates (second substrate group) can be caused to be on standby while being immersed in the immersion liquid in the standby tank. As a result, it is possible to prevent the other plurality of substrates (second substrate group) from being dried during standby.

In addition, preferably, the substrate treatment system further includes a stocker device that is adjacent to the batch treatment device and the interface device, in which the stocker device includes a load port that loads and unloads the carrier, and a carrier transport robot that transports the carrier between at least the load port and the first carrier placement shelf. The carrier transport robot can transport the carrier between at least the load port and the first carrier placement shelf. In addition, even in a case where a length of the single-wafer treatment device in the first horizontal direction is changed, it is not necessary to change the configuration of the stocker device.

In the substrate treatment system, an example of the relay substrate transport mechanism includes a belt conveyor. In the substrate treatment system, an example of the relay substrate transport mechanism includes a movable relay hand that holds one substrate. In addition, in the substrate treatment system described above, an example of the substrate handling mechanism is preferably a plurality of hands that respectively hold the plurality of substrates, and includes the plurality of hands that are integrally movable.

According to the substrate treatment system according to the present invention, it is possible to freely change the configurations of the batch treatment device and the single-wafer treatment device.

### BRIEF DESCRIPTION OF DRAWINGS

For the purpose of illustrating the invention, there are shown in the drawings several forms which are presently preferred, it being understood, however, that the invention is not limited to the precise arrangement and instrumentalities shown.
FIG. 1 is a plan view illustrating a schematic configuration of a substrate treatment system according to a first embodiment;
FIGS. 2A to 2C are side views for describing a substrate handling mechanism and a first posture turning mechanism;
FIG. 3 is a plan view illustrating a configuration of an interface device and its vicinity;
FIGS. 4A to 4H are diagrams for describing four holding modes of a pair of chucks of a second batch transport mechanism;
FIGS. 5A to 5C are diagrams for describing a second posture turning mechanism;
FIGS. 6A to 6C are diagrams for describing the second posture turning mechanism;
FIGS. 7A and 7B are diagrams for describing the second posture turning mechanism;
FIG. 8 is a right side view of a single-wafer treatment device;
FIG. 9 is a flowchart for describing an operation of the substrate treatment system;
FIGS. 10A and 10B are plan views for describing an effect of the substrate treatment system;
FIGS. 11A and 11B are plan views for describing the effect of the substrate treatment system;
FIG. 12 is a plan view illustrating a schematic configuration of a substrate treatment system according to a second embodiment;
FIG. 13 is a plan view illustrating configurations of an interface device according to a modification example and its vicinity;
FIG. 14 is a plan view illustrating configurations of an interface device according to another modification example and its vicinity; and
FIGS. 15A and 15B are diagrams for describing rotation of substrates about a vertical axis by a pusher mechanism of an underwater posture turning unit.

### DETAILED DESCRIPTION

### First Embodiment

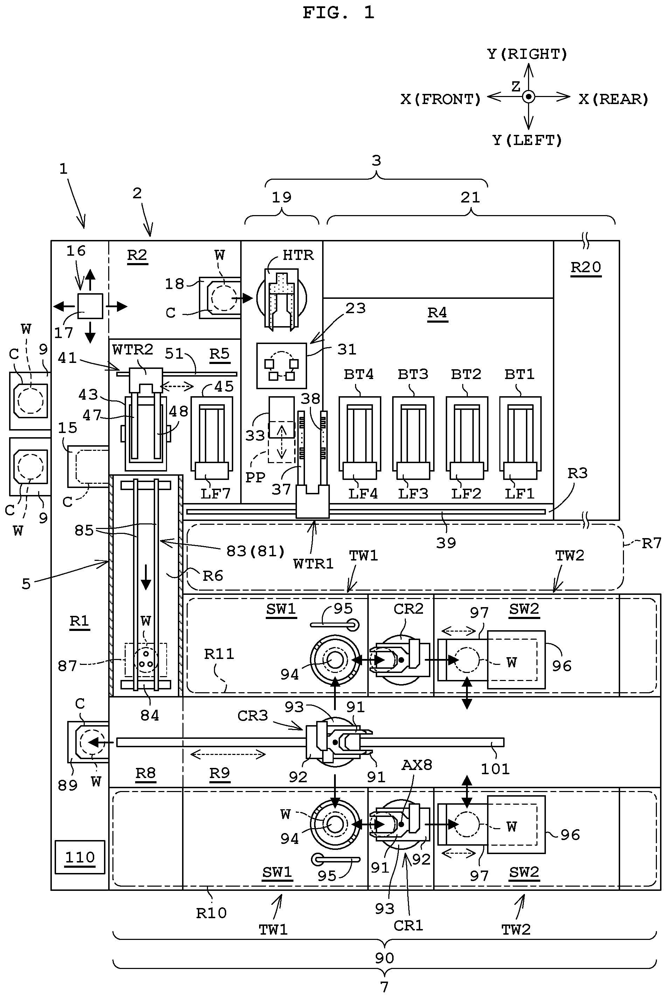

Hereinafter, a first embodiment of the present invention will be described with reference to the drawings. FIG. 1 is a plan view illustrating a schematic configuration of a substrate treatment system according to a first embodiment.

In the present specification, for convenience, a direction in which a transfer block 19 (described later) and a treatment block 21 (described later) in a batch treatment device 3 are arranged will be referred to as a "front-rear direction X". The front-rear direction X is horizontal. In the front-rear direction X, for example, a direction from the treatment block 21 toward the transfer block 19 will be referred to as a "front side". A direction opposite to the front will be referred to as a "rear side". A horizontal direction orthogonal to the front-rear direction X will be referred to as a "width direction Y". One direction in the "width direction Y" will be referred to as a "right side" as appropriate. A direction opposite to the right side will be referred to as a "left side". A direction perpendicular to the horizontal direction will be referred to as a "vertical direction Z". In each drawing, front, rear, right, left, up, and down are illustrated for reference as appropriate.

### <1. Overall configuration>

FIG. 1 will be referred to. A substrate treatment system 1 performs treatment on a substrate W. The substrate treatment system 1 performs, for example, chemical liquid treatment, washing treatment, drying treatment, and the like on the substrate W.

The substrate treatment system 1 includes a stocker device 2, a batch treatment device 3, an interface device 5, and a single-wafer treatment device 7. That is, the substrate treatment system 1 is a hybrid system including the batch treatment device 3 and the single-wafer treatment device 7. The batch treatment device 3 collectively performs treatment on a plurality of (for example, twenty-five or fifty) substrates W. The single-wafer treatment device 7 performs treatment on a plurality of substrates W one by one. The interface device 5 connects the batch treatment device 3 and the single-wafer treatment device 7.

The stocker device 2, the batch treatment device 3, the interface device 5, and the single-wafer treatment device 7 are arranged in a C shape or a U shape. A specific description will be made. The batch treatment device 3 extends to the rear side. The single-wafer treatment device 7 is disposed facing the batch treatment device 3 to be aligned in the width direction Y orthogonal to the rear side. The interface device 5 is adjacent to one end side of each of the batch treatment device 3 and the single-wafer treatment device 7. The interface device 5 is disposed to extend in the width direction Y.

The rear side corresponds to a first horizontal direction of the present invention. The width direction Y corresponds to a second horizontal direction of the present invention.

### <2. Stocker device>

The stocker device 2 accommodates at least one carrier C. The stocker device 2 is adjacent to the batch treatment device 3, the interface device 5, and the single-wafer treatment device 7. The carrier C stores a plurality of (for example, twenty-five) substrates W at predetermined intervals (for example, 10 mm) in a horizontal posture. In the carrier C, the plurality of substrates W are aligned in the vertical direction Z or the thickness direction of each substrate W. As the carrier C, for example, a front opening unify pod (FOUP) is used, but the carrier C is not limited thereto.

The stocker device 2 includes a plurality of (for example, two) load ports 9, a main body region R1, and an extension region R2. The two load ports 9 are adjacent to the front of the main body region R1. The two load ports 9 are disposed in the width direction Y. Each of the two load ports 9 is for loading and unloading the carrier C. The main body region R1 and the extension region R2 are formed in an L shape in a plan view. The main body region R1 is formed to extend in the width direction Y. The extension region R2 is connected to a rear side of a right end portion of the main body region R1.

The stocker device 2 includes a storage shelf 15 and a carrier transport robot 16. The storage shelf 15 is disposed in the main body region R1. The storage shelf 15 is a shelf for storing the carrier C. The carrier C is placed on the storage shelf 15.

The carrier transport robot 16 transports the carrier C between the two load ports 9, the two shelves 18 and 89, and the storage shelf 15. The carrier transport robot 16 includes, for example, a gripping portion (gripper) 17 that grips a protrusion provided on the upper surface of the carrier C. The gripping portion 17 is movable in the horizontal direction (the front-rear direction X and the width direction Y) and the vertical direction Z by the carrier transport robot 16. The carrier transport robot 16 is driven by one or more electric motors. The carrier transport robot 16 may include a movable support that supports the lower surface of the carrier C.

### <3. Batch treatment device>

An outline of the batch treatment device 3 will be described. The batch treatment device 3 takes out a plurality of (for example, twenty-five) substrates W from the carrier C transported to the shelf 18. The batch treatment device 3 turns the taken-out plurality of (for example, twenty-five) substrates W from a horizontal posture to a vertical posture by using a first posture turning mechanism 23 (described later). The batch treatment device 3 performs predetermined batch treatment on a plurality of (for example, twenty-five or fifty) substrates W turned into the vertical posture. The batch treatment device 3 transports a plurality of (for example, twenty-five or fifty) substrates W subjected to batch treatment to the interface device 5.

Next, details of the batch treatment device 3 will be described. The batch treatment device 3 includes a shelf 18, a transfer block 19, a treatment block 21, and a batch substrate transport region R3. The shelf 18 is disposed in the extension region R2. The carrier C is placed on the shelf 18. The transfer block 19 is adjacent to the rear side of the shelf 18. The treatment block 21 is adjacent to the rear side of the transfer block 19. The treatment block 21 extends to the rear side.

The batch substrate transport region R3 is disposed adjacent to the transfer block 19 and the treatment block 21 on the side where the single-wafer treatment device 7 is disposed. One end side of the batch substrate transport region R3 extends to the interface device 5. The other end side of the batch substrate transport region R3 extends to the rear side. In other words, the batch substrate transport region R3 is adjacent to the left side of the transfer block 19, the treatment block 21, and a posture turning region R5 (described later). In addition, the batch substrate transport region R3 may be adjacent to the rear side of a relay region R6 (described later).

### <3-1. Transfer block>

The transfer block 19 includes a substrate handling mechanism (robot) HTR and a first posture turning mechanism 23. The substrate handling mechanism HTR is provided on the rear side of the shelf 18. The substrate handling mechanism HTR takes out a plurality of (for example, twenty-five) substrates W in a horizontal posture from the carrier C placed on the shelf 18, and transports the taken-out substrates W to the first posture turning mechanism 23.

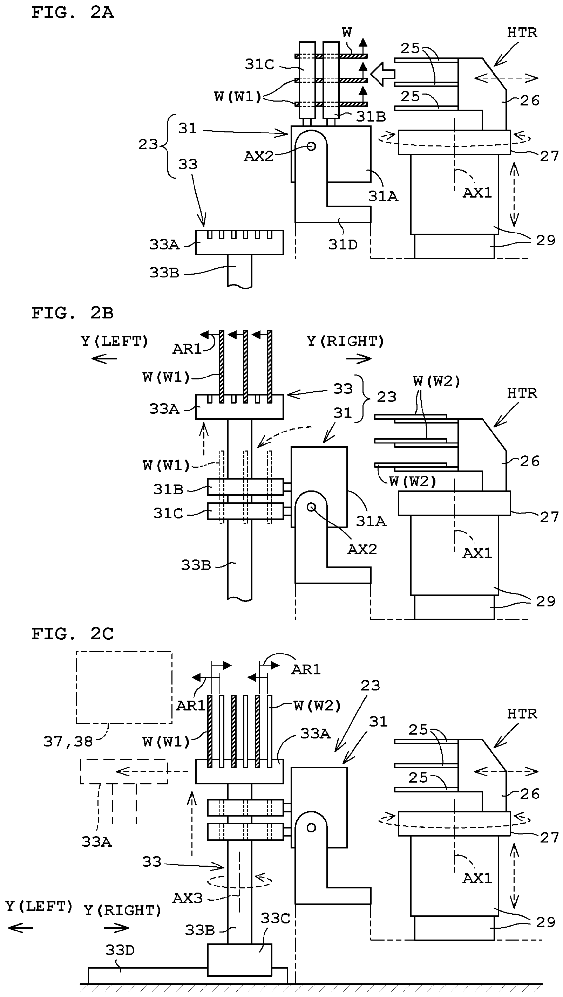

FIGS. 2A to 2C will be referred to. The substrate handling mechanism HTR includes a plurality of (for example, twenty-five) hands 25. Each hand 25 holds one substrate W. In FIGS. 2A to 2C, for convenience of illustration, it is assumed that the substrate handling mechanism HTR includes three hands 25. In addition, it is assumed that a pair of horizontal holding portions 31B and a pair of vertical holding portions 31C that will be described later hold three substrates W. Further, it is assumed that a pusher 33A that will be described later supports six substrates W.

The substrate handling mechanism HTR further includes a hand support portion 26, an advance/retract portion 27, and an elevation rotation portion 29. The hand support portion 26 supports a plurality of hands 25. As a result, the plurality of hands 25 are integrally movable. The advance/retract portion 27 advances and retracts the plurality of hands 25 via the hand support portion 26. The elevation rotation portion 29 lifts and lowers the plurality of hands 25 and the advance/retract portion 27. The elevation rotation portion 29 rotates the advance/retract portion 27 about the vertical axis AX1 to change an orientation of the hand 25. The elevation rotation portion 29 is fixed to a floor surface and does not move in the horizontal direction (the front-rear direction X and the width direction Y). The advance/retract portion 27 and the elevation rotation portion 29 each include an electric motor. In addition, the substrate handling mechanism HTR may include a movable hand (not illustrated) for transporting only one substrate W, separately from the hand 25.

The first posture turning mechanism 23 includes a posture turning unit 31 and a pusher mechanism 33. The substrate handling mechanism HTR, the posture turning unit 31, and the pusher mechanism 33 are disposed on the left side in this order. In other words, the substrate handling mechanism HTR, the posture turning unit 31, and the pusher mechanism 33 (including a pusher 33A) are disposed in the width direction Y orthogonal to the rear side from the transfer block 19 toward the treatment block 21.

The posture turning unit 31 turns a plurality of (for example, twenty-five) substrates W received from the substrate handling mechanism HTR from the horizontal posture to the vertical posture. As illustrated in FIG. 2A, the posture turning unit 31 includes a support base 31A, a pair of horizontal holding portions 31B, a pair of vertical holding portions 31C, and a rotation driving portion 31D. The pair of horizontal holding portions 31B and the pair of vertical holding portions 31C are provided on the support base 31A. When the substrates W are in the horizontal posture, the pair of horizontal holding portions 31B supports the substrate W from below while being in contact with the lower surfaces of the respective substrates W. In addition, when the substrates W are in the vertical posture, the pair of vertical holding portions 31C holds the substrates W. The rotation driving portion 31D rotates the support base 31A about a horizontal axis AX2.

As illustrated in FIG. 2C, the pusher mechanism 33 includes a pusher 33A, an elevation rotation portion 33B, a horizontal movement portion 33C, and a rail 33D. The pusher 33A holds the lower portion of each of the plurality of (for example, twenty-five or fifty) substrates W turned into the vertical posture by the posture turning unit 31. In other words, the pusher 33A holds the plurality of substrates W received from the substrate handling mechanism HTR in the vertical posture via the posture turning unit 31. The elevation rotation portion 33B lifts and lowers the pusher 33A in the vertical direction Z. The elevation rotation portion 33B rotates the pusher 33A about a vertical axis AX3. As a result, an orientation of the device surface of the substrate W indicated by an arrow AR1 may be set to any orientation.

The horizontal movement portion 33C horizontally moves the pusher 33A and the elevation rotation portion 33B along the rail 33D. The rail 33D extends in the width direction Y. Note that each of the rotation driving portion 31D, the elevation rotation portion 33B, and the horizontal movement portion 33C includes an electric motor.

The shelf 18 corresponds to a first carrier placement shelf of the present invention. The posture turning unit 31 corresponds to a first posture turning unit of the present invention. The pusher 33A corresponds to a vertical holder of the present invention. The plurality of substrates of the present invention may be, for example, some of twenty-five or fifty substrates W.

Here, an operation of the first posture turning mechanism 23 will be described. For example, each of four batch treatment tanks BT1 to BT4 that will be described later of the treatment block 21 collectively performs treatment on the fifty substrates W corresponding to two carriers C. Thus, the pusher 33A holds the fifty substrates W (W1, W2) while the posture of the fifty substrates W is turned twenty-five substrates W at a time. The twenty-five substrates W1 will be referred to as a first substrate group. The twenty-five substrates W2 will be referred to as a second substrate group. The fifty substrates W (W1, W2) will be referred to as a treatment substrate group. In a case where the substrates W1 and W2 are not particularly distinguished, the substrate W1 and the substrate W2 are described as a substrate W.

FIG. 2A will be referred to. The posture turning unit 31 receives twenty-five substrates W1 from the substrate handling mechanism HTR. In this case, the twenty-five substrates W1 are in a horizontal posture and aligned at a full pitch (for example, at intervals of 10 mm). The full pitch will also be referred to as a normal pitch. The device surface of each substrate W1 faces upward. The device surface of the substrate W is a surface on which an electronic circuit is formed, and will be referred to as a "front surface". A back surface of the substrate W is a surface on which no electronic circuit is formed. A surface on an opposite side to the device surface is the back surface.

FIG. 2B will be referred to. The rotation driving portion 31D of the posture turning unit 31 rotates the pair of horizontal holding portions 31B and the like by 90 degrees about the horizontal axis AX2 to turn the posture of the twenty-five substrates W1 from the horizontal posture to the vertical posture. Thereafter, the pusher mechanism 33 lifts the pusher 33A to receive the twenty-five substrates W1 from the posture turning unit 31. Thereafter, the pusher mechanism 33 rotates the pusher 33A by 180 degrees about the vertical axis AX3. Thus, the orientation of the twenty-five substrates W1 is changed from the left side to the right side.

Thereafter, the posture turning unit 31 receives twenty-five substrates W2 from the substrate handling mechanism HTR, and turns the posture of the twenty-five substrates W2 from the horizontal posture to the vertical posture. Thereafter, the pusher mechanism 33 lifts the pusher 33A holding the twenty-five substrates W1. As a result, the pusher 33A further receives the twenty-five substrates W2.

FIG. 2C will be referred to. The pusher 33A holds the fifty substrates W (W1, W2). The twenty-five substrates W1 and the twenty-five substrates W2 are alternately disposed. The fifty substrates W are aligned at a half pitch (for example, at intervals of 5 mm). Note that the half pitch is an interval half of the full pitch. Thereafter, the pusher mechanism 33 moves the pusher 33A holding the fifty substrates W to a substrate delivery position PP below a pair of chucks 37 and 38 (described later) of a batch transport mechanism WTR1 (described later) along the rail 33D.

### <3-2. Treatment block (batch treatment block)>

The treatment block 21 includes a batch treatment region R4. The batch treatment region R4 is adjacent to the rear side of the transfer block 19. The batch treatment region R4 includes a plurality of (for example, four) batch treatment tanks BT1 to BT4. The four batch treatment tanks BT1 to BT4 are arranged side by side on the rear side to which the batch treatment device 3 extends or in the front-rear direction X. Each of the four batch treatment tanks BT1 to BT4 collectively immerses a plurality of (for example, twenty-five or fifty) substrates W. Each of the four batch treatment tanks BT1 to BT4 stores a treatment solution (for example, chemical liquid or pure water) for immersing the plurality of substrates W.

The four batch treatment tanks BT1 to BT4 include, for example, two chemical liquid treatment tanks BT1 and BT3 and two water washing treatment tanks BT2 and BT4. The chemical liquid treatment tank BT1 and the water washing treatment tank BT2 configure one set, and the chemical liquid treatment tank BT3 and the water washing treatment tank BT4 configure the other set. A combination of a chemical liquid treatment tank and a water washing treatment tank is not limited to this example. The number of batch treatment tanks is not limited to four, and may be one or two or more.

Each of the two chemical liquid treatment tanks BT1 and BT3 performs etching treatment by using a chemical liquid. As the chemical liquid, for example, a phosphoric acid is used. Each of the chemical liquid treatment tanks BT1 and BT3 stores a chemical liquid supplied from a chemical liquid ejection pipe (not illustrated). Each of the two water washing treatment tanks BT2 and BT4 performs pure water washing treatment of washing away the chemical liquid attached to the plurality of substrates W with pure water. For example, deionized water (DIW) is used as pure water. Each of the water washing treatment tanks BT2 and BT4 stores pure water supplied from a pure water ejection pipe (not illustrated).

Four lifters LF1 to LF4 are provided in the four batch treatment tanks BT1 to BT4, respectively. For example, the lifter LF1 holds the substrates W in a vertical posture aligned at a half pitch (for example, an interval of 5 mm) which is a predetermined interval. The lifter LF1 lifts and lowers the plurality of substrates W between a treatment position inside the batch treatment tank BT1 and a delivery position above the batch treatment tank BT1. The other three lifters LF2 to LF4 are configured similarly to the lifter LF1. Note that a region R20 illustrated in FIG. 1 is, for example, a region for preparing a chemical liquid to be supplied to the chemical liquid treatment tanks BT1 and BT3 (for example, a region for adjusting a temperature and a concentration of the supplied chemical liquid).

### <3-3. Batch substrate transport region>

The batch substrate transport region R3 is disposed on the opposite side to the substrate handling mechanism HTR via the first posture turning mechanism 23 (including the pusher 33A). One end of the batch substrate transport region R3 extends to a posture turning region R5 (described later) of the interface device 5. The other end of the batch substrate transport region R3 extends to the rear side. In other words, the batch substrate transport region R3 extends in the front-rear direction X.

The batch substrate transport region R3 includes a batch transport mechanism (robot) WTR1. The batch transport mechanism WTR1 transports a plurality of substrates W in a vertical posture between the four batch treatment tanks BT1 to BT4, the first posture turning mechanism 23 (including the pusher 33A), and the interface device 5 (a standby tank 45 that will be described later).

The four batch treatment tanks BT1 to BT4, the substrate delivery position PP, the standby tank 45 (described later), and the underwater posture turning unit 43 (described later) are aligned in a line in the front-rear direction X. Therefore, the batch transport mechanism WTR1 transports the plurality of substrates W in a vertical posture in parallel to the rear side or the front-rear direction X.

The batch transport mechanism WTR1 includes a pair of chucks 37 and 38 and a guide rail 39. The pair of chucks 37 and 38 includes, for example, fifty pairs of holding grooves for holding the fifty substrates W. That is, each of the two chucks 37 and 38 includes fifty holding grooves. Each of the two chucks 37 and 38 extends in parallel to the width direction Y (FIG. 1) in a plan view. The batch transport mechanism WTR1 opens and closes the two chucks 37 and 38. The guide rail 39 extends in the front-rear direction X. The batch transport mechanism WTR1 moves the pair of chucks 37 and 38 along the guide rail 39. The batch transport mechanism WTR1 is driven by an electric motor.

### <4. Interface device>

An outline of the interface device 5 will be described. The interface device 5 receives a plurality of substrates W subjected to predetermined batch treatment in one of the two water washing treatment tanks BT2 and BT4 from the batch transport mechanism WTR1. The interface device 5 turns the received plurality of substrates W from a vertical posture to a horizontal posture. The interface device 5 transports the plurality of substrates W turned into the horizontal posture to the single-wafer treatment device 7.

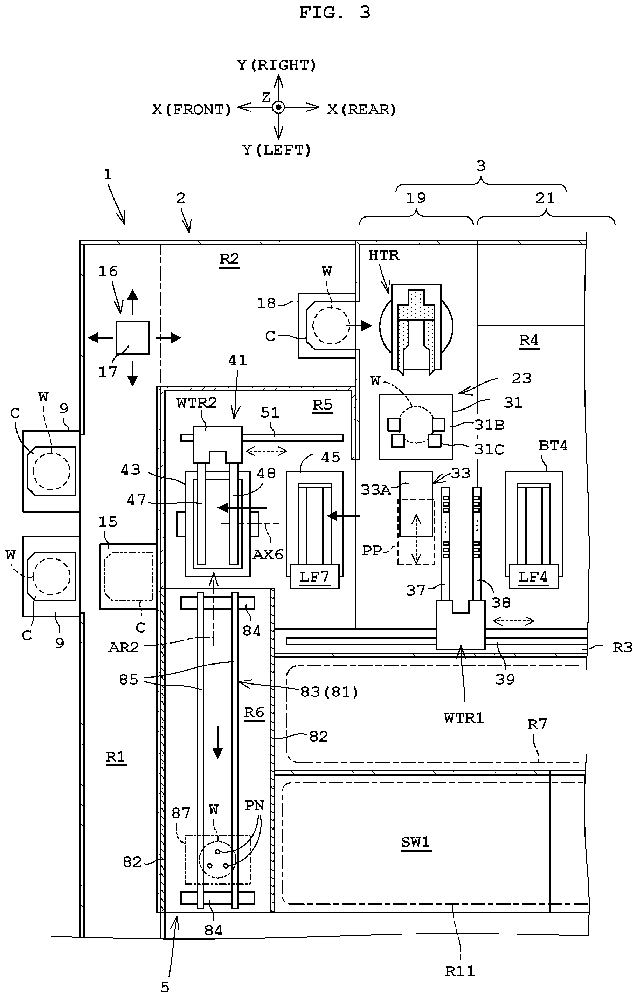

Next, details of the interface device 5 will be described. FIGS. 1 and 3 will be referred to. The interface device 5 includes a posture turning region R5 and a relay region R6 disposed in the width direction Y. The posture turning region R5 is disposed on the opposite side to the treatment block 21 via the transfer block 19. That is, the posture turning region R5 is adjacent to the front side of the transfer block 19. The posture turning region R5 is adjacent to the left side of the extension region R2 of the stocker device 2 and is adjacent to the rear side of the main body region R1. The posture turning region R5 is disposed on the left side of the shelf 18.

### <4-1. Second posture turning mechanism>

The posture turning region R5 includes a second posture turning mechanism 41. The second posture turning mechanism 41 turns a posture of the plurality of substrates W subjected to treatment by the batch treatment device 3 from the vertical posture to the horizontal posture. The second posture turning mechanism 41 includes an underwater posture turning unit 43, a standby tank 45, and a second batch transport mechanism WTR2. The underwater posture turning unit 43 corresponds to a second posture turning unit of the present invention.

The standby tank 45 is provided on the front side of the substrate delivery position PP. The standby tank 45 is provided between the transfer block 19 and the underwater posture turning unit 43. The standby tank 45 is provided with a lifter LF7. The lifter LF7 is configured similarly to the lifter LF1. The standby tank 45 stores an immersion liquid in which the plurality of substrates W are immersed in a vertical posture. Pure water is used as the immersion liquid. Pure water (for example, DIW) is supplied from a pure water ejection pipe (not illustrated).

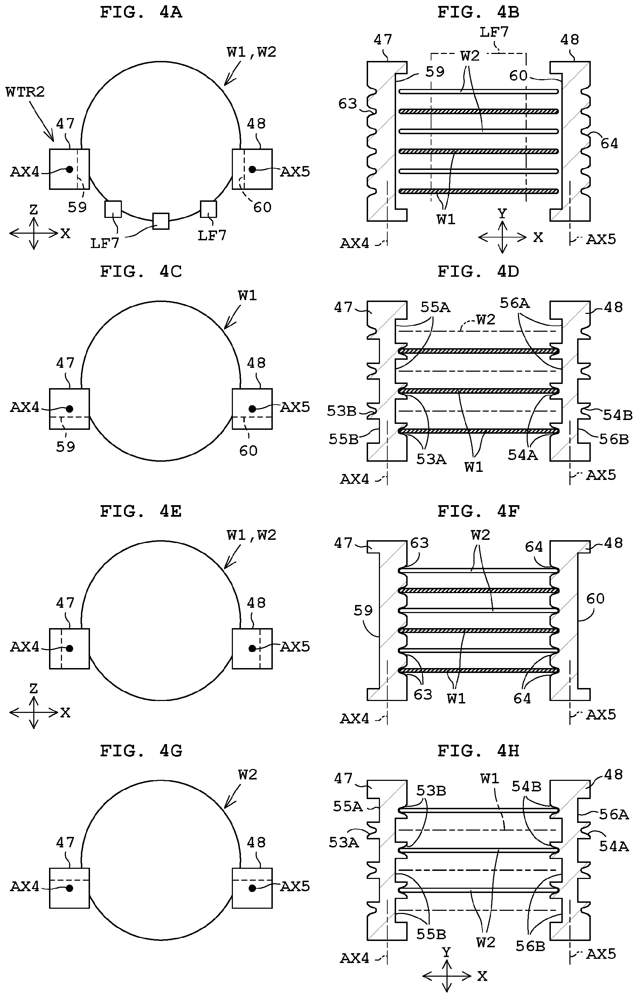

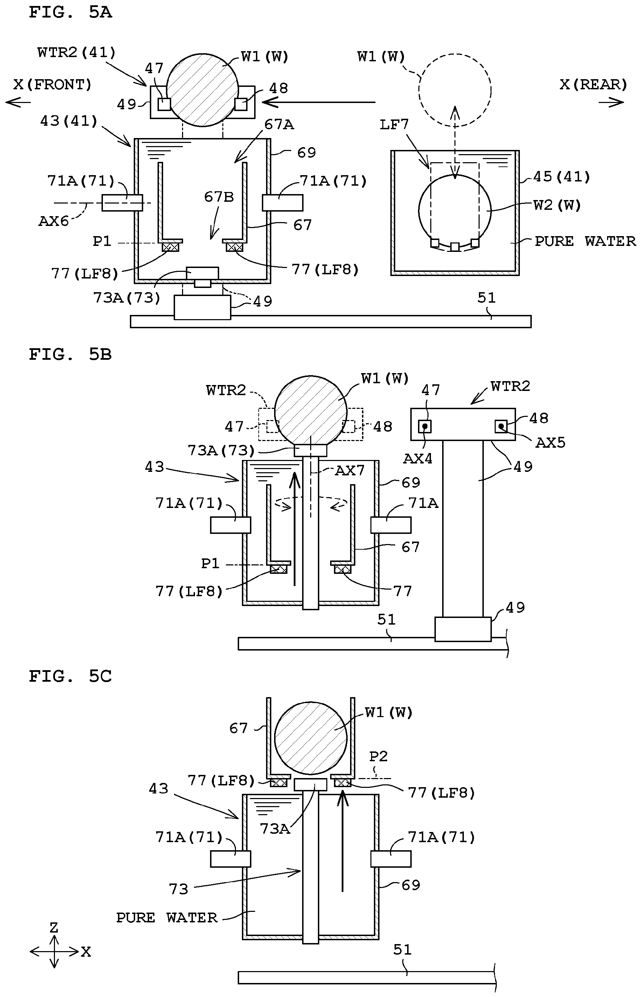

The second batch transport mechanism WTR2 transports a plurality of (for example, twenty-five) substrates W from the standby tank 45 to the underwater posture turning unit 43 in the vertical posture along the guide rail 51. The second batch transport mechanism WTR2 includes a pair of chucks 47 and 48, a support column 49 (see FIG. 5B), and a guide rail 51. The support column 49 supports the pair of chucks 47 and 48 at the upper end thereof. The support column 49 rotates the first chuck 47 about a horizontal axis AX4 and rotates the second chuck 48 about a horizontal axis AX5 (see FIG. 4A). Each of the horizontal axes AX4 and AX5 extends in the width direction Y.

The pair of chucks 47 and 48 and the support column 49 are movable along the guide rail 51 extending in the front-rear direction X. The guide rail 51 is provided at a height position closer to the floor surface of the posture turning region R5 than the ceiling surface. The guide rail 51 is provided directly or indirectly on the floor surface of the posture turning region R5. The second batch transport mechanism WTR2 is driven by, for example, an electric motor.

The guide rail 51 is provided on the opposite side to the batch substrate transport region R3 via the standby tank 45. That is, the guide rail 51 is provided on the right side of the underwater posture turning unit 43 and the standby tank 45. As a result, it is possible to prevent the second batch transport mechanism WTR2 that transports the substrate W along the guide rail 51 from interfering with the substrate transport from the underwater posture turning unit 43 to the relay substrate transport mechanism 81 by crossing between the underwater posture turning unit 43 and a relay substrate transport mechanism 81 (described later).

Next, the pair of chucks 47 and 48 will be described. For example, it is assumed that a treatment substrate group (for example, the fifty substrates W1 and W2) in which a plurality of (for example, twenty-five) substrates W1 and another plurality of (for example, twenty-five) substrates W2 are alternately disposed is immersed in an immersion liquid in the standby tank 45. In this case, the second batch transport mechanism WTR2 takes out a plurality of (twenty-five) substrates W1 (W2) from the treatment substrate group in the standby tank 45 by using the pair of chucks 47 and 48, and transports the plurality of (twenty-five) taken-out substrates W1 (W2) to the underwater posture turning unit 43.

The pair of chucks 47 and 48 has a plurality of (for example, four) holding modes. FIGS. 4A to 4H are diagrams for describing four holding modes. FIGS. 4A, 4C, 4E, and 4G are side views illustrating the pair of chucks 47 and 48 when viewed as an arrow AR2 illustrated in FIG. 3. FIGS. 4B, 4D, 4F, and 4H are cross-sectional views of the pair of chucks 47 and 48. In FIGS. 4A to 4H, six substrates W1 and W2 will be described for convenience of illustration.

FIGS. 4A and 4B are diagrams illustrating a first holding mode. In the first holding mode, the pair of chucks 47 and 48 includes a pair of passage grooves 59 and 60. In the case of the first holding mode, the pair of chucks 47 and 48 cannot hold any of the fifty substrates W1 and W2 held by the lifter LF7. That is, the fifty substrates W1 and W2 pass between the chucks 47 and 48 (the passage grooves 59 and 60).

FIGS. 4C and 4D are diagrams illustrating the second holding mode. In the second holding mode, the pair of chucks 47 and 48 includes a plurality of pairs (for example, twenty-five pairs) of holding grooves 53A and 54A and a plurality of pairs (for example, twenty-five pairs) of passage grooves 55A and 56A. The twenty-five pairs of holding grooves 53A and 54A and the twenty-five pairs of passage grooves 55A and 56A are alternately disposed. The first chuck 47 includes twenty-five holding grooves 53A and twenty-five passage grooves 55A alternately disposed. The second chuck 48 includes twenty-five holding grooves 54A and twenty-five passage grooves 56A alternately disposed. The pair of chucks 47 and 48 in the second holding mode holds twenty-five substrates W1 out of fifty substrates W1 and W2.

FIGS. 4E and 4F are diagrams illustrating a third holding mode. In the third holding mode, the pair of chucks 47 and 48 includes, for example, fifty pairs of holding grooves 63 and 64. The pair of chucks 47 and 48 can hold the fifty substrates W1 and W2 by using fifty pairs of holding grooves 63 and 64.

FIGS. 4G and 4H are diagrams illustrating a fourth hold mode. In the fourth holding mode, the pair of chucks 47 and 48 includes a plurality of pairs (for example, twenty-five pairs) of holding grooves 53B and 54B and a plurality of pairs (for example, twenty-five pairs) of passage grooves 55B and 56B. The twenty-five pairs of holding grooves 53B and 54B and the twenty-five pairs of passage grooves 55B and 56B are alternately disposed. The pair of chucks 47 and 48 in the fourth holding mode holds twenty-five substrates W2 out of fifty substrates W1 and W2.

As illustrated in FIGS. 4B and 4F, for example, in the first chuck 47, the holding groove 63 related to the third holding mode is provided on the surface opposite to the passage groove 59 related to the first holding mode via the horizontal axis AX4. As illustrated in FIGS. 4D and 4H, for example, in the first chuck 47, the holding groove 53B and the passage groove 55B related to the fourth holding mode are provided on the surface opposite to the holding groove 53A and the passage groove 55A related to the second holding mode via the horizontal axis AX4.

For example, based on the first holding mode illustrated in FIG. 4A, the first chuck 47 is rotated clockwise by 90 degrees about the horizontal axis AX4, and the second chuck 48 is rotated counterclockwise by 90 degrees about the horizontal axis AX5. As a result, the chucks 47 and 48 enter the second holding mode illustrated in FIG. 4C. Based on the first holding mode, the first chuck 47 is rotated clockwise by 180 degrees about the horizontal axis AX4, and the second chuck 48 is rotated counterclockwise by 180 degrees about the horizontal axis AX5. As a result, the chucks 47 and 48 enter the third holding mode illustrated in FIG. 4E.

Similarly, based on the first holding mode, the first chuck 47 is rotated 270 degrees clockwise, and the second chuck 48 is rotated 270 degrees counterclockwise. As a result, the chucks 47 and 48 enter the fourth holding mode illustrated in FIG. 4G.

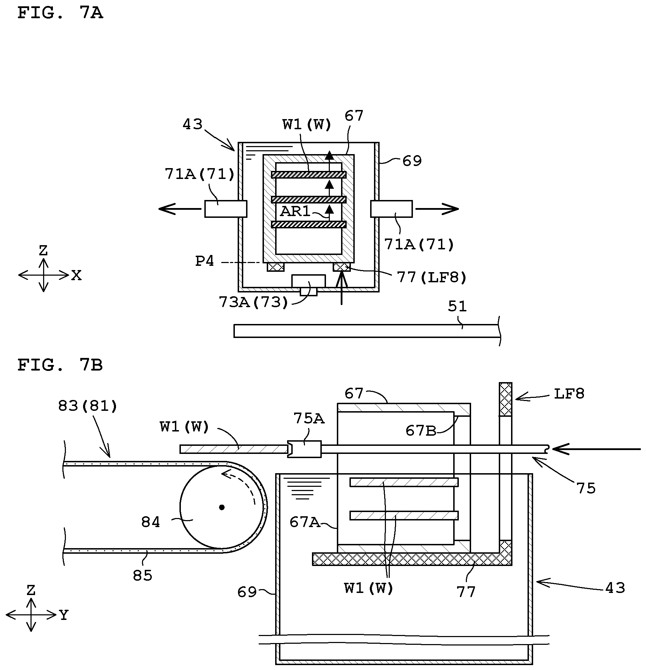

Next, the underwater posture turning unit 43 will be described. The underwater posture turning unit 43 turns the plurality of substrates W from the vertical posture to the horizontal posture. As illustrated in FIGS. 3 and 5A, the underwater posture turning unit 43 is provided on the front side of the standby tank 45. The underwater posture turning unit 43 includes an in-tank carrier 67, a lifter LF8, a posture turning tank 69, a rotation mechanism 71, a pusher mechanism 73, and a horizontal pushing mechanism 75 (see FIG. 7B).

The in-tank carrier 67 can store a plurality of (for example, twenty-five or fifty) substrates W. The in-tank carrier 67 includes a gateway 67A and a back opening 67B. The gateway 67A is an opening through which the substrate W passes. The back opening 67B faces the gateway 67A. The back opening 67B is formed to have a width smaller than a diameter of the stored substrate W in the radial direction of the substrate W. Therefore, the plurality of substrates W cannot pass through the back opening 67B.

The lifter LF8 includes two carrier support portions 77 that support the in-tank carrier 67. The lifter LF8 lifts and lowers the two carrier support portions 77. The posture turning tank 69 accommodates an in-tank carrier 67, two carrier support portions 77 of the lifter LF8, and a pusher 73A (described later). The posture turning tank 69 stores pure water (for example, DIW) supplied from a pure water ejection pipe (not illustrated). As a result, the in-tank carrier 67 can be immersed in pure water in the posture turning tank 69.

The rotation mechanism 71 includes two shafts 71A facing each other. Each of the two shafts 71A penetrates the posture turning tank 69. The rotation mechanism 71 holds the in-tank carrier 67 by sandwiching the in-tank carrier 67 between the two shafts 71A. Further, the rotation mechanism 71 can rotate the in-tank carrier 67 held by the two shafts 71A about the horizontal axis AX6 of the shaft 71A. The horizontal axis AX6 extends in the front-rear direction X.

The pusher mechanism 73 includes a pusher 73A that holds lower portions of a plurality of (for example, twenty-five) substrates W in a vertical posture. The pusher mechanism 73 can move up and down the pusher 73A and rotate the pusher 73A about the vertical axis AX7 (see FIG. 5B). The horizontal pushing mechanism 75 includes a pushing member 75A that pushes one substrate W in a horizontal posture (see FIG. 7B). The pushing member 75A is moved to the left side while passing through the back opening 67B and the gateway 67A when the gateway 67A of the in-tank carrier 67 faces the left side. The lifter LF8, the rotation mechanism 71, the pusher mechanism 73, and the horizontal pushing mechanism 75 are each driven by at least one of an electric motor and an air cylinder.

### <4-2. Operation of second posture turning mechanism>

Here, an operation of the second posture turning mechanism 41 will be described. FIG. 5A will be referred to. The fifty substrates W held in a vertical posture by the lifter LF7 are immersed in pure water in the standby tank 45. As illustrated in FIG. 2C, the fifty substrates W are configured such that the twenty-five substrates W1 and the twenty-five substrates W2 are alternately disposed.

The second batch transport mechanism WTR2 is moved to above the standby tank 45. The second batch transport mechanism WTR2 sets the pair of chucks 47 and 48 to the first holding mode (see FIGS. 4A and 4B). Thereafter, the lifter LF7 lifts the fifty substrates W to a position higher than the pair of chucks 47 and 48 while allowing the fifty substrates W to pass between the chucks 47 and 48.

Thereafter, the second batch transport mechanism WTR2 sets the pair of chucks 47 and 48 to the second holding mode (see FIGS. 4C and 4D). Thereafter, the lifter LF7 lowers the fifty substrates W. As a result, the second batch transport mechanism WTR2 receives the twenty-five substrates W1 out of the fifty substrates W from the lifter LF7. Therefore, the twenty-five substrates W2 remain in the lifter LF7. The lifter LF7 immerses the twenty-five substrates W2 in pure water in the standby tank 45. Thereafter, the second batch transport mechanism WTR2 transports the twenty-five substrates W1 to above the posture turning tank 69 and the pusher 73A.

FIG. 5B will be referred to. The two carrier support portions 77 of the lifter LF8 support the in-tank carrier 67 with the gateway 67A facing upward. The pusher mechanism 73 lifts the pusher 73A while allowing the pusher 73A to pass through the back opening 67B and the gateway 67A between the two carrier support portions 77. As a result, the pusher 73A holds the lower portions of the twenty-five substrates W1 held by the pair of chucks 47 and 48, thereby receiving the twenty-five substrates W1 from the pair of chucks 47 and 48 indicated by dashed lines.

Thereafter, the second batch transport mechanism WTR2 sets the pair of chucks 47 and 48 to the first holding mode (see FIGS. 4A and 4B). Thereafter, the pusher mechanism 73 lowers the pusher 73A while allowing the twenty-five substrates W1 held by the pusher 73A to pass between the chucks 47 and 48. The pusher 73A is lowered to a position not interfering with the pair of chucks 47 and 48. Thereafter, the second batch transport mechanism WTR2 is moved from above the pusher 73A.

Thereafter, the pusher mechanism 73 rotates the twenty-five substrates W1 about the vertical axis AX7 so that the device surface faces upward when the twenty-five substrates W1 are turned into the horizontal posture. Thus, the orientation of the twenty-five substrates W1 is adjusted. This adjustment is performed, for example, at a position higher than the water surface of the pure water in the posture turning tank 69.

FIG. 5C will be referred to. The lifter LF8 lifts the two carrier support portions 77 supporting the in-tank carrier 67 with the gateway 67A facing upward from a position P1 to a position P2. As a result, the twenty-five substrates W1 held by the pusher 73A are stored in the in-tank carrier 67. Note that the position P2 is, for example, a position higher than the water surface of the pure water in the posture turning tank 69.

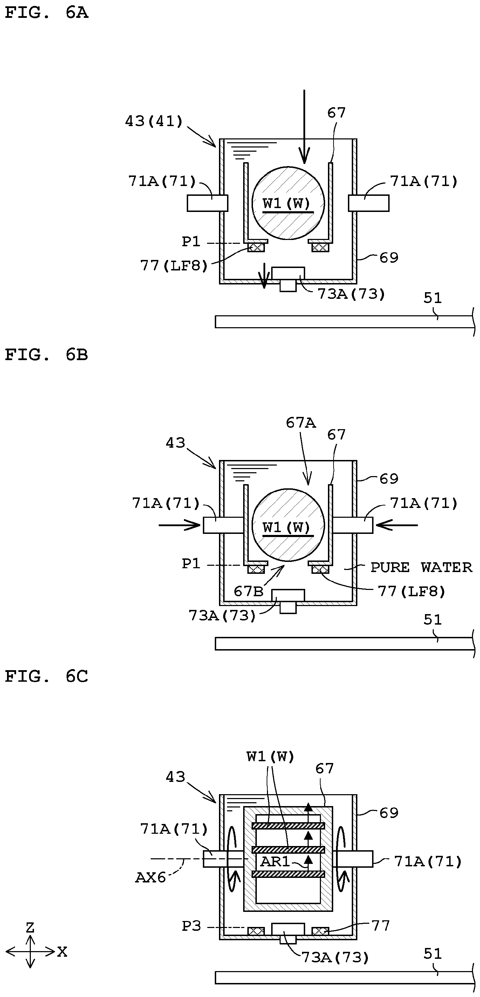

FIG. 6A will be referred to. Thereafter, the pusher mechanism 73 lowers the pusher 73A to the bottom surface in the posture turning tank 69. The lifter LF8 lowers the two carrier support portions 77 from the position P2 to the position P1. As a result, the twenty-five substrates W1 stored in the in-tank carrier 67 are immersed in the pure water in the posture turning tank 69.

FIG. 6B will be referred to. Thereafter, the rotation mechanism 71 holds the in-tank carrier 67 with the two shafts 71A. FIG. 6C will be referred to. Thereafter, the lifter LF8 lowers the two carrier support portions 77 from the position P1 to the position P3. As a result, the in-tank carrier 67 is held only by the two shafts 71A. A position P3 is a position near the bottom surface in the posture turning tank 69. Thereafter, the rotation mechanism 71 rotates the in-tank carrier 67 by 90 degrees about a horizontal axis AX6. As a result, the twenty-five substrates W1 in the in-tank carrier 67 are turned from the vertical posture to the horizontal posture. In this case, the device surface of each substrate W1 faces upward.

FIG. 7A will be referred to. Thereafter, the lifter LF8 lifts the two carrier support portions 77 from the position P3 to a position P4. As a result, the two carrier support portions 77 come into contact with the lower surface of the in-tank carrier 67. Thereafter, the rotation mechanism 71 separates the two shafts 71A from the in-tank carrier 67. As a result, the in-tank carrier 67 is held by only the two carrier support portions 77.

FIG. 7B will be referred to. Thereafter, the lifter LF8 lifts the two carrier support portions 77 such that one substrate W1 comes out of the pure water in the posture turning tank 69. Thereafter, the horizontal pushing mechanism 75 pushes the one substrate W1 taken out from the pure water by the pushing member 75A to the left side. The pushed substrate W1 is transported to a relay substrate transport mechanism 81 (described later) of the relay region R6.

Thereafter, after the twenty-five substrates W1 are transported from the in-tank carrier 67, the remaining twenty-five substrates W2 immersed in the pure water in the standby tank 45 are turned into a horizontal posture. When the twenty-five substrates W2 are received from the lifter LF7, the second batch transport mechanism WTR2 sets the pair of chucks 47 and 48 to the fourth holding mode (see FIG. 4G and FIG. 4H). In addition, the posture turning of the twenty-five substrates W2 is performed in the same manner as the posture turning of the twenty-five substrates W1 (see FIGS. 5A to 7B).

### <4-3. Relay substrate transport mechanism>

FIGS. 1 and 3 will be referred to. The relay region R6 is adjacent to or connected to the left side of the posture turning region R5. The relay region R6 extends in the width direction Y. That is, the relay region R6 extends to the left side from the posture turning region R5. The relay region R6 includes a relay substrate transport mechanism 81. The relay substrate transport mechanism 81 transports the plurality of substrates W turned into the horizontal posture by the second posture turning mechanism 41 to the single-wafer treatment device 7. The relay substrate transport mechanism 81 includes a belt conveyor 83. The relay region R6 blocks an atmosphere outside the substrate treatment system 1 by using a housing 82.

The belt conveyor 83 includes two pulleys 84, two belts 85, and a pin lifting/lowering unit 87 (see FIG. 3). The two belts 85 are stretched around the two pulleys 84. The pin lifting/lowering unit 87 is provided at a tip portion of the belt conveyor 83. The pin lifting/lowering unit 87 has three lift pins PN, and lifts one substrate W on the two belts 85 by using the three lift pins PN. At least one of the two pulleys 84 and the pin lifting/lowering unit 87 are each driven by an electric motor.

### <5. Single-wafer treatment device>

FIG. 1 will be referred to. The single-wafer treatment device 7 performs predetermined single-wafer treatment on a plurality of substrates W received from the interface device 5 one by one, and transports the plurality of substrates W subjected to the single-wafer treatment to the carrier C placed on the shelf 89.

The single-wafer treatment device 7 is provided on the opposite side to the transfer block 19 and the treatment block 21 via the batch substrate transport region R3 of the batch treatment device 3. That is, the single-wafer treatment device 7 is provided on the left side of the batch treatment device 3. A maintenance region R7 is provided between the batch treatment device 3 and the single-wafer treatment device 7.

The single-wafer treatment device 7 includes a shelf 89 on which the carrier C is placed and a single-wafer treatment block 90. The single-wafer treatment block 90 is adjacent to the rear side of the shelf 89. The single-wafer treatment block 90 includes a plurality of single-wafer treatment chambers (a first single-wafer treatment chamber SW1 and a second single-wafer treatment chamber SW2) (described later) for performing predetermined treatment on a plurality of substrates W subjected to treatment in the batch treatment device 3 one by one. The shelf 89 is disposed in the main body region R1. The shelf 89 corresponds to a second carrier placement shelf of the present invention.

The single-wafer treatment block 90 includes a delivery region R8, a single-wafer transport region R9, and two single-wafer treatment regions R10 and R11. The delivery region R8 is adjacent to the tip of the relay region R6 and the shelf 89. The single-wafer transport region R9 extends to the rear side from the delivery region R8. The first single-wafer treatment region R10 is adjacent to the left side of the single-wafer transport region R9. The second single-wafer treatment region R11 is adjacent to the right side of the single-wafer transport region R9. Each of the two single-wafer treatment regions R10 and R11 extends in the front-rear direction X.

The first single-wafer treatment region R10 includes a front tower TW1, a rear tower TW2, and a substrate transport robot CR1. The front tower TW1, the substrate transport robot CR1, and the rear tower TW2 are provided in this order along the single-wafer transport region R9.

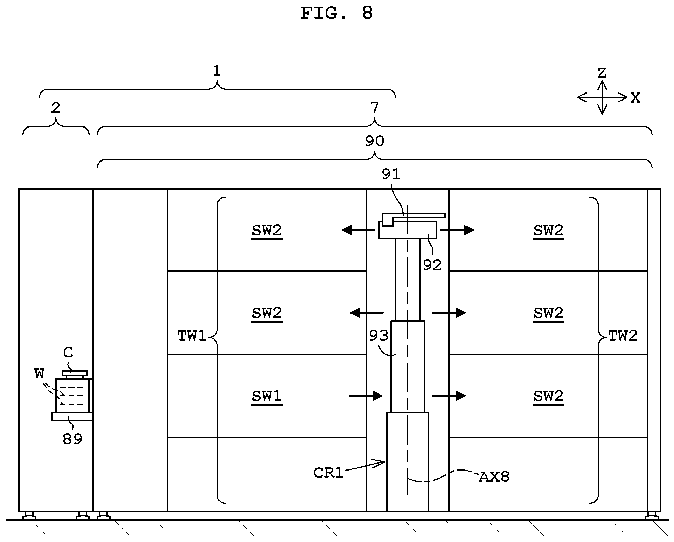

The front tower TW1 is provided on the front side of the substrate transport robot CR1. The rear tower TW2 is provided on the rear side of the substrate transport robot CR1. As illustrated in FIG. 8, the front tower TW1 includes one first single-wafer treatment chamber SW1 and two second single-wafer treatment chambers SW2 stacked in a vertical direction Z. The rear tower TW2 includes three second single-wafer treatment chambers SW2 stacked in the vertical direction Z. That is, the first single-wafer treatment region R10 includes a total of six single-wafer treatment chambers (the first single-wafer treatment chamber SW1 and the second single-wafer treatment chambers SW2). Each of the single-wafer treatment chambers (the first single-wafer treatment chamber SW1 and the second single-wafer treatment chambers SW2) is provided along the single-wafer transport region R9, and performs predetermined treatment on one substrate W.

The substrate transport robot CR1 includes a hand 91, an advance/retract portion 92, and an elevation rotation portion 93. The hand 91 holds one substrate W in a horizontal posture. The advance/retract portion 92 advances and retracts the hand 91. The elevation rotation portion 93 lifts and lowers the hand 91 and the advance/retract portion 92. The elevation rotation portion 93 rotates the hand 91 and the advance/retract portion 92 about a vertical axis AX8 to change an orientation of the hand 91. The substrate transport robot CR1 transports one substrate W in a horizontal posture between the three single-wafer treatment chambers (the first single-wafer treatment chamber SW1 and the second single-wafer treatment chambers SW2) of the front tower TW1 and the three second single-wafer treatment chambers SW2 of the rear tower TW2.

The second single-wafer treatment region R11 includes a front tower TW1, a rear tower TW2, and a substrate transport robot CR2, similarly to the first single-wafer treatment region R10. That is, the second single-wafer treatment region R11 includes six single-wafer treatment chambers (a first single-wafer treatment chamber SW1 and second single-wafer treatment chambers SW2). The substrate transport robot CR2 is configured similarly to the substrate transport robot CR1. The type and number of single-wafer treatment chambers included in the front tower TW1 and the rear tower TW2 are set as appropriate.

The first single-wafer treatment chamber SW1 includes, for example, a holding rotation unit 94 and a nozzle 95. The holding rotation unit 94 includes a spin chuck that holds one substrate W in a horizontal posture and an electric motor that rotates the spin chuck about a vertical axis passing through the center of the substrate W. The nozzle 95 supplies a treatment solution onto the substrate W held by the holding rotation unit 94. As the treatment solution, for example, pure water (for example, DIW) and isopropyl alcohol (IPA) are used. The first single-wafer treatment chamber SW1 performs, for example, washing treatment on the substrate W with pure water, and then forms a liquid film of IPA on the upper surface of the substrate W.

Each of the second single-wafer treatment chambers SW2 performs, for example, drying treatment with a supercritical fluid. For example, carbon dioxide is used as the fluid. In a case where the fluid is carbon dioxide, a supercritical state is obtained when the critical temperature is 31°C and the critical pressure is 7.38 MPa. By performing the drying treatment with the supercritical fluid, it is possible to make the pattern collapse in the substrate W less likely to occur.

The second single-wafer treatment chamber SW2 includes a chamber body (container) 96, a support tray 97, and a lid portion. The chamber body 96 includes a treatment space provided inside, an opening for inserting the substrate W into the treatment space, a supply port, and an exhaust port. The substrate W is accommodated in the treatment space while being supported by the support tray 97. The lid portion closes the opening of the chamber body 96. For example, each of the second single-wafer treatment chambers SW2 brings the fluid into the supercritical state, and supplies the supercritical fluid from the supply port to the treatment space in the chamber body 96. The drying treatment is performed on one substrate W by using the supercritical fluid supplied to the treatment space.

The single-wafer transport region R9 includes a substrate transport robot CR3. The substrate transport robot CR3 transports one substrate W in a horizontal posture between the relay substrate transport mechanism 81, the twelve single-wafer treatment chambers (the first single-wafer treatment chamber SW1 and the second single-wafer treatment chambers SW2), and the carrier C placed on the shelf 89. In addition, the substrate transport robot CR3 receives the substrate W transported by the relay substrate transport mechanism 81, and transports the received substrate W to one first single-wafer treatment chamber SW1 among the plurality of (for example, twelve) single-wafer treatment chambers (the first single-wafer treatment chambers SW1 and the second single-wafer treatment chambers SW2). The substrate transport robot CR3 stores the substrate W subjected to treatment in one second single-wafer treatment chamber SW2 among the plurality of (for example, twelve) single-wafer treatment chambers (the first single-wafer treatment chambers SW1 and the second single-wafer treatment chambers SW2) in the carrier C placed on the shelf 89.

Similarly to the substrate transport robot CR1, the substrate transport robot CR3 includes a hand 91, an advance/retract portion 92, and an elevation rotation portion 93. The substrate transport robot CR3 further includes a guide rail 101 extending in the front-rear direction X. One end of the guide rail 101 extends to the delivery region R8. The elevation rotation portion 93 and the like of the substrate transport robot CR3 is movable along the guide rail 101. The substrate transport robot CR3 preferably includes two hands 91. In this case, the first hand 91 is used to transport the wet substrate W, and the second hand 91 is used to transport the substrate W dried in the second single-wafer treatment chamber SW2. Each of the substrate transport robots CR1 to CR3 corresponds to a horizontal substrate transport robot of the present invention.

### <6. Control unit>

The substrate treatment system 1 includes a control unit 110 (see FIG. 1) and a storage unit (not illustrated). The control unit 110 controls each constituent of the substrate treatment system 1. The control unit 110 includes one or more processors such as a central processing unit (CPU). The storage unit includes, for example, at least one of a read-only memory (ROM), a random-access memory (RAM), and a hard disk. The storage unit stores a computer program necessary for controlling each constituent of the substrate treatment system 1.

### <7. Operation of substrate treatment system>

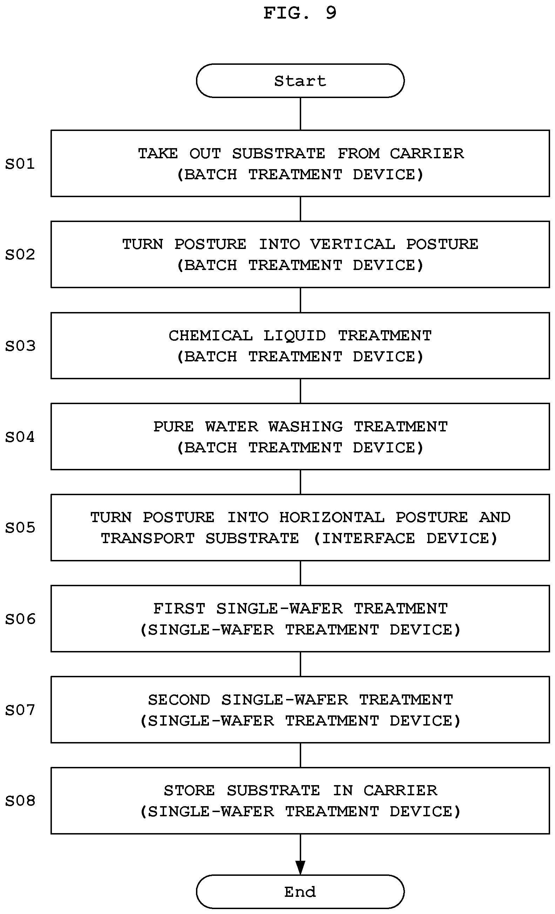

Next, an operation of the substrate treatment system 1 will be described with reference to a flowchart of FIG. 9. FIG. 1 will be referred to. An external transport robot (not illustrated) transports two carriers C to the load port 9.

### [Step S01] Taking out substrate from carrier

The carrier transport robot 16 of the stocker device 2 transports the first carrier C in which twenty-five substrates W1 before treatment are stored from the load port 9 to the shelf 18. Thereafter, the substrate handling mechanism HTR of the batch treatment device 3 takes out the twenty-five substrates W1 (first substrate group) from the first carrier C transported to the shelf 18, and transports the twenty-five substrates W1 to the posture turning unit 31.

Thereafter, the carrier transport robot 16 transports the first carrier C (empty carrier) from which the twenty-five substrates W1 have been taken out from the shelf 18 to the shelf 89. Thereafter, the carrier transport robot 16 transports the second carrier C in which twenty-five substrates W2 before treatment are stored from the load port 9 to the shelf 18. Thereafter, the substrate handling mechanism HTR takes out the twenty-five substrates W2 (second substrate group) from the second carrier C transported to the shelf 18, and transports the twenty-five substrates W2 to the posture turning unit 31.

Thereafter, the carrier transport robot 16 transports the second carrier C (empty carrier) from which the twenty-five substrates W2 have been taken out from the shelf 18 to the storage shelf 15. The second carrier C is stored in the storage shelf 15 until the second carrier C can be transported to the shelf 89.

### [Step S02] Turning posture into vertical posture

As illustrated in FIGS. 2A to 2C, the posture turning unit 31 individually turns the twenty-five substrates W1 and the twenty-five substrates W2 from the horizontal posture to the vertical posture. In addition, the pusher 33A of the pusher mechanism 33 holds the fifty substrates W (the substrates W1 and W2) in which the twenty-five substrates W1 and the twenty-five substrates W2 are alternately disposed in a vertical posture. Thereafter, the pusher mechanism 33 transports the fifty substrates W to the substrate delivery position PP.

### [Step S03] Chemical liquid treatment

The batch transport mechanism WTR1 receives the fifty substrates W in a vertical posture from the pusher mechanism 33 at the substrate delivery position PP, and transports the fifty substrates W to one of the two lifters LF1 and LF3 of the two chemical liquid treatment tanks BT1 and BT3.

For example, the batch transport mechanism WTR1 transports the fifty substrates W in a vertical posture to the lifter LF1 of the chemical liquid treatment tank BT1. The lifter LF1 receives the fifty substrates W at a position above the chemical liquid treatment tank BT1. The lifter LF1 immerses the fifty substrates W in a chemical liquid (for example, phosphoric acid) in the chemical liquid treatment tank BT1. As a result, etching treatment (batch treatment) is performed. After the etching treatment, the lifter LF1 pulls up the fifty substrates W from the phosphoric acid in the chemical liquid treatment tank BT1. In a case where the fifty substrates W are transported to the lifter LF3 of another chemical liquid treatment tank BT3, the same treatment as in the chemical liquid treatment tank BT1 is performed.

### [Step S04] Pure water washing treatment

The batch transport mechanism WTR1 receives, for example, the fifty substrates W in a vertical posture from the lifter LF1, and transports the fifty substrates W to the lifter LF2 of the water washing treatment tank BT2. The lifter LF2 receives the fifty substrates W at a position above the water washing treatment tank BT2. The lifter LF2 immerses the fifty substrates W in pure water in the water washing treatment tank BT2. Accordingly, washing treatment (batch treatment) is performed.

In a case where the batch transport mechanism WTR1 receives the fifty substrates W in the vertical posture from the lifter LF3, the batch transport mechanism WTR1 transports the fifty substrates W to the lifter LF4 of the water washing treatment tank BT4. The lifter LF4 immerses the fifty substrates W in pure water in the water washing treatment tank BT4.

### [Step S05] Turning posture into horizontal posture and transporting substrate

The batch transport mechanism WTR1 receives the fifty substrates W subjected to the pure water washing treatment from one of the two lifters LF2 and LF4. When the fifty substrates W are transported, for example, the lifter LF2 pulls up the fifty substrates W from the pure water in the water washing treatment tank BT2. The batch transport mechanism WTR1 transports the received fifty substrates W to the lifter LF7 of the standby tank 45 of the interface device 5 across the substrate delivery position PP of the first posture turning mechanism 23. The lifter LF7 receives the fifty substrates W at a position above the standby tank 45.

As illustrated in FIGS. 5A to 7B, the underwater posture turning unit 43 individually turns the twenty-five substrates W1 and the twenty-five substrates W2 from the vertical posture to the horizontal posture. The underwater posture turning unit 43 transports the twenty-five substrates W1 (twenty-five substrates W2) turned into the horizontal posture one by one to the belt conveyor 83 of the relay substrate transport mechanism 81. The belt conveyor 83 transports one substrate W in the horizontal posture to the left side up to a position above the pin lifting/lowering unit 87. Thereafter, the pin lifting/lowering unit 87 lifts one substrate W on the two belts 85 by using the three lift pins PN.

### [Step S06] First single-wafer treatment

The substrate transport robot CR3 uses the first hand 91 to receive one wet substrate W lifted by the three lift pins PN of the pin lifting/lowering unit 87. The substrate transport robot CR3 transports the substrate W received by the first hand 91 to one of the two first single-wafer treatment chambers SW1 of the two front towers TW1.

Each of the first single-wafer treatment chambers SW1 holds and rotates the substrate W with the device surface facing upward in the horizontal posture by using the holding rotation unit 94, and supplies pure water from the nozzle 95 to the device surface. Thereafter, each first single-wafer treatment chamber SW1 supplies IPA from the nozzle 95 to the device surface (upper surface) of the substrate W, and replaces the pure water of the substrate W with IPA.

### [Step S07] Second single-wafer treatment

It is assumed that the substrate W is subjected to treatment in the first single-wafer treatment chamber SW1 of the first single-wafer treatment region R10. In this case, the substrate transport robot CR1 transports the substrate W subjected to replacement with IPA from the first single-wafer treatment chamber SW1 of the first single-wafer treatment region R10 to any one of the five second single-wafer treatment chambers SW2 in the first single-wafer treatment region R10. Similarly, it is assumed that the substrate W is subjected to treatment in the first single-wafer treatment chamber SW1 of the second single-wafer treatment region R11. In this case, the substrate transport robot CR2 transports the substrate W subjected to replacement with IPA from the first single-wafer treatment chamber SW1 of the second single-wafer treatment region R11 to any one of the five second single-wafer treatment chambers SW2 of the second single-wafer treatment region R11.

Each of the second single-wafer treatment chambers SW2 performs drying treatment on one substrate W with carbon dioxide (supercritical fluid) in a supercritical state. The pattern collapse of a pattern surface (device surface) of the substrate W is curbed due to the drying treatment using the supercritical fluid.

### [Step S08] Storing substrate in carrier

The substrate transport robot CR3 uses the second hand 91 out of the two hands 91 to receive one substrate W1 from the second single-wafer treatment chamber SW2 that has performed the drying treatment. The substrate transport robot CR3 transports the substrate W1 received by the second hand 91 to the first carrier C placed on the shelf 89.

When the twenty-five substrates W1 are stored in the first carrier C, the carrier transport robot 16 transports the first carrier C from the shelf 89 to one of the two load ports 9. In addition, the carrier transport robot 16 transports the second carrier C (empty carrier) from the storage shelf 15 to the shelf 89 after the first carrier C is transported.

Similarly, the substrate transport robot CR3 uses the second hand 91 to receive one substrate W2 from the second single-wafer treatment chamber SW2 that has performed the drying treatment. The substrate transport robot CR3 transports the substrate W2 received by the second hand 91 to the second carrier C placed on the shelf 89. When the twenty-five substrates W2 are stored in the second carrier C, the carrier transport robot 16 transports the second carrier C from the shelf 89 to one of the two load ports 9. An external transport mechanism (not illustrated) sequentially transports two carriers C from the load port 9 to the next destination.

According to the present embodiment, the posture turning region R5 of the interface device 5 is provided on the opposite side to the treatment block 21 having the four batch treatment tanks BT1 to BT4 via the transfer block 19 of the batch treatment device 3. For example, it is assumed that a length of the batch treatment device 3 may be changed on the rear side to which the batch treatment device 3 extends as the number of batch treatment tanks of the batch treatment device 3 is increased or decreased. Even in this case, it is not necessary to change at least the configurations of the transfer block 19 and the interface device 5 (the posture turning region R5 and the relay region R6) of the batch treatment device 3. Therefore, it is possible to freely change the configurations of the batch treatment device 3 and the single-wafer treatment device 7.

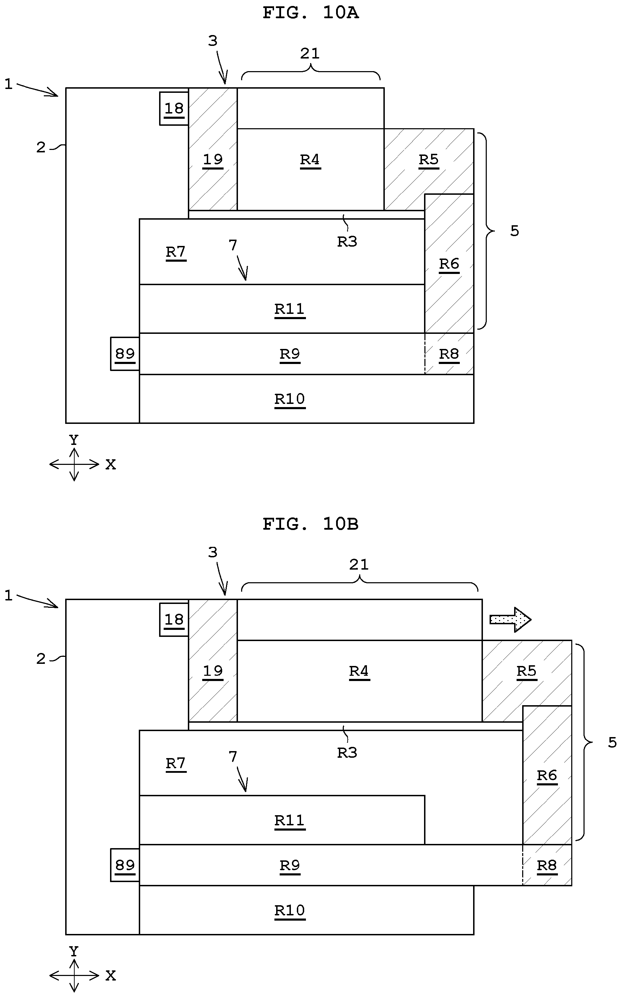

The description of this effect will be supplemented. FIG. 10A is a plan view illustrating the substrate treatment system 1 in which the interface device 5 is connected on the rear side of the batch treatment device 3 and on the rear side of the single-wafer treatment device 7. In this case, for example, as illustrated in FIG. 10B, the batch treatment device 3 (treatment block 21) illustrated in FIG. 10A is lengthened to the rear side. With this change, for example, as illustrated in FIG. 10B, it is necessary to lengthen the single-wafer transport region R9 in the front-rear direction X.

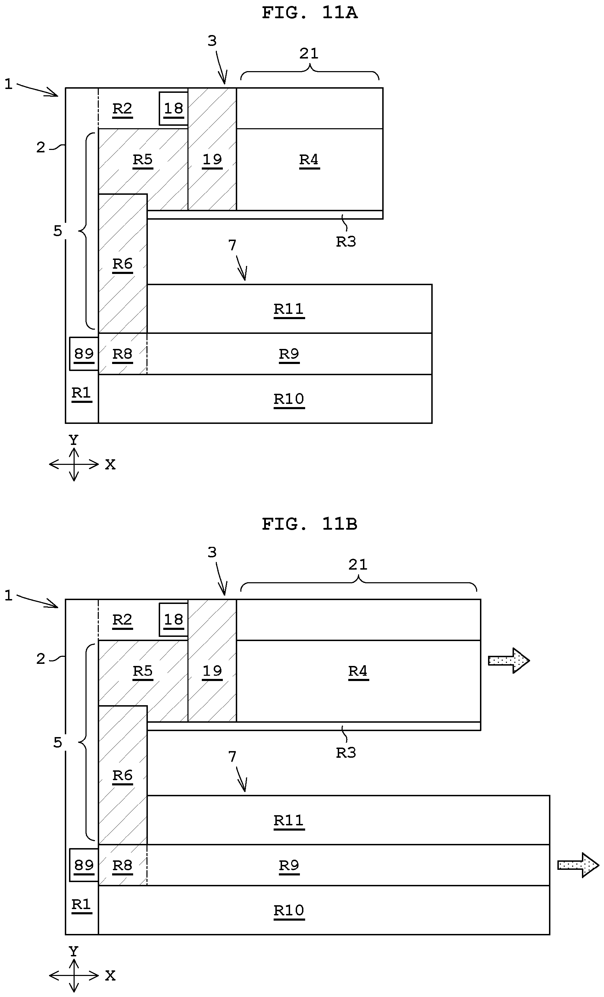

In contrast, FIG. 11A is a plan view illustrating a substrate treatment system 1 according to the first embodiment. In this case, for example, as illustrated in FIG. 11B, the batch treatment device 3 (treatment block 21) illustrated in FIG. 11A is lengthened to the rear side. Even with such a change, for example, it is not necessary to change the configurations of the transfer block 19 and the interface device 5 (the posture turning region R5 and the relay region R6). In addition, it is not necessary to similarly change the configurations of the delivery region R8 and the stocker device 2 and the positions of the two shelves 18 and 89. Note that "there is no need to change" does not limit a change.

Therefore, even if the batch treatment device 3 is lengthened to the rear side, the stocker device 2, the transfer block 19, the interface device 5, and the like can be used without any change. This is the same even when the single-wafer treatment device 7 is lengthened to the rear side. Therefore, it is possible to freely change (for example, a change to expand and contract in the front-rear direction X) the configurations of the batch treatment device 3 and the single-wafer treatment device 7 .

In addition, since the posture turning region R5 is provided on the opposite side to the treatment block 21 via the transfer block 19, it is possible to prevent the relay region R6 of the interface device 5 from intersecting the batch substrate transport region R3 in a plan view. Therefore, a configuration is prevented from being complicated. In addition, the single-wafer treatment device 7 is provided on the opposite side to the transfer block 19 via the batch substrate transport region R3. Therefore, an extent to which the interface device 5 blocks one (front) side of the transfer block 19 in a plan view (in FIG. 3, the interface device 5 does not block between the shelf 18 and the transfer block 19) is able to be curbed. In addition, for example, a wide maintenance region can be secured on the opposite side to the batch substrate transport region R3 via the batch treatment tank BT4.

In addition, the second posture turning mechanism 41 includes the underwater posture turning unit 43 that turns a plurality of substrates W from a vertical posture to a horizontal posture, and the standby tank 45 that is provided between the transfer block 19 and the underwater posture turning unit 43 and stores an immersion liquid in which the plurality of substrates W are immersed in the vertical posture. The second posture turning mechanism 41 can cause the plurality of substrates W to be on standby in the vertical posture while immersing the plurality of substrates W in the immersion liquid stored in the standby tank 45.

In addition, the second batch transport mechanism WTR2 includes, for example, a pair of chucks 47 and 48 in which a plurality of pairs of holding grooves 53A and 54A and a plurality of pairs of passage grooves 55A and 56A are alternately disposed. In a case where the treatment substrate group in which the plurality of substrates W1 and the other plurality of substrates W2 are alternately disposed is immersed in the immersion liquid in the standby tank 45, the second batch transport mechanism WTR2 takes out, for example, the plurality of substrates W1 from the treatment substrate group by using the pair of chucks 47 and 48, and transports the plurality of taken-out substrates W1 to the underwater posture turning unit 43.

The second batch transport mechanism WTR2 can take out the plurality of substrates W1 (first substrate group) from the treatment substrate group in which the plurality of substrates W1 (first substrate group) and the other plurality of substrates W2 (second substrate group) are alternately disposed. The plurality of taken-out substrates W1 (first substrate group) is turned into a horizontal posture by the underwater posture turning unit 43. On the other hand, the other plurality of substrates W2 (second substrate group) can be caused to be on standby while being immersed in the immersion liquid in the standby tank 45. As a result, the other plurality of substrates W2 (second substrate group) can be prevented from being dried during standby. Further, by taking out the plurality of substrates W1 (first substrate group), a pitch of each of the plurality of substrates W1 (first substrate group) and the other plurality of substrates W2 (second substrate group) (an interval between adjacent two substrates W1 (W2)) can be widened.

### Second Embodiment

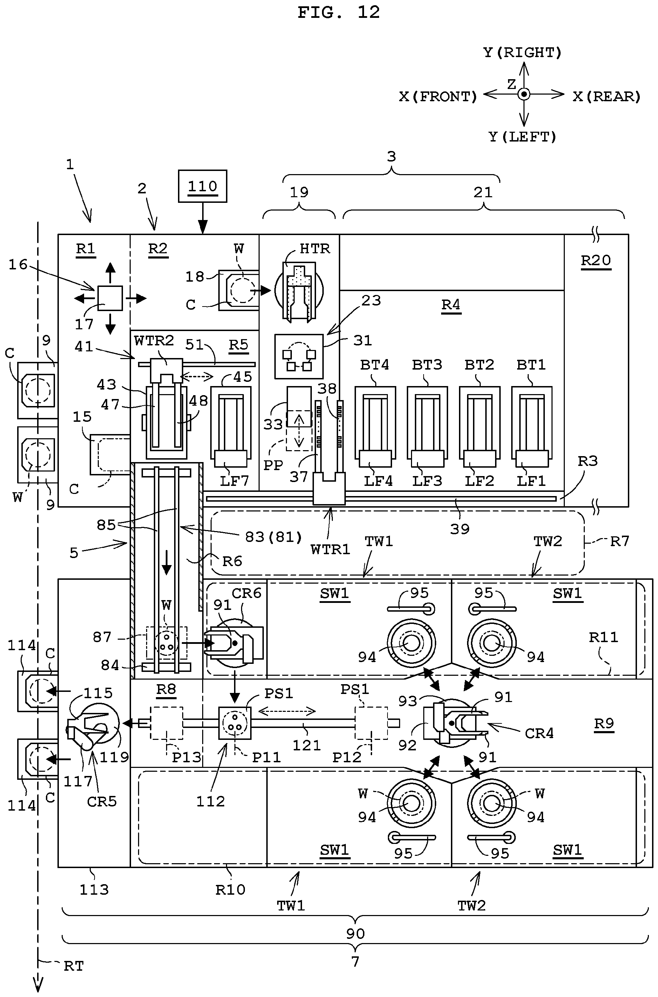

Next, a second embodiment of the present invention will be described with reference to the drawings. Note that the description overlapping with the first embodiment will be omitted. FIG. 12 is a plan view illustrating a schematic configuration of a substrate treatment system 1 according to the second embodiment.

In the first embodiment, the stocker device 2 transports the carrier C to the shelf 18 adjacent to the batch treatment device 3, and receives the carrier C from the shelf 89 adjacent to the single-wafer treatment device 7. In this respect, the stocker device 2 does not need to receive the carrier C from the shelf 89. That is, the stocker device 2 does not need to be accessible to the shelf 89.

In the first embodiment, the single-wafer treatment device 7 includes the first single-wafer treatment chamber SW1 and the second single-wafer treatment chamber SW2. In this regard, in the second embodiment, the single-wafer treatment device 7 may include the first single-wafer treatment chamber SW1 without including the second single-wafer treatment chamber SW2.

In the first embodiment, the single-wafer transport region R9 includes the substrate transport robot CR3 capable of transporting the substrate W in the front-rear direction X along the guide rail 101. In this regard, in the second embodiment, the single-wafer transport region R9 may include a shuttle mechanism 112 and a substrate transport robot CR4.

FIG. 12 will be referred to. The main body region R1 of the stocker device 2 is not adjacent to the single-wafer treatment device 7. In the second embodiment, a single-wafer treatment block 90 of the single-wafer treatment device 7 includes an indexer region 113. In addition, the single-wafer treatment device 7 includes a plurality of (for example, two) shelves 114. Note that one shelf 114 may be provided. Each shelf 114 corresponds to a second carrier placement shelf of the present invention.

The indexer region 113 is adjacent to the front side of the delivery region R8. The two shelves 114 are adjacent to the front side of the indexer region 113. In a certain section, a transport path RT (see FIG. 12) of an external transport mechanism (for example, an overhead hoist transport (OHT)) (not illustrated) is formed to linearly extend in the width direction Y. In a plan view, a plurality of load ports 9 and a plurality of shelves 114 are disposed to overlap the transport path RT.

In a case where the substrate handling mechanism HTR of the batch treatment device 3 takes out twenty-five substrates W from the carrier C placed on the shelf 18, the carrier transport robot 16 transports the empty carrier C from the shelf 18 to the load port 9. The external transport mechanism transports the empty carrier C from the load port 9 to the shelf 114 along the transport path RT.

The indexer region 113 includes a substrate transport robot CR5. The substrate transport robot CR5 includes a hand 115, an articulated arm 117, and a lifting/lowering stage 119. The hand 115 holds one substrate W and is movable. The articulated arm 117 is, for example, a selective compliance assembly robot arm (SCARA) type robot arm. A basal end portion of the articulated arm 117 is attached to the lifting/lowering stage 119 to be rotatable about the vertical axis. The hand 115 is attached to a distal end portion of the articulated arm 117. The articulated arm 117 and the lifting/lowering stage 119 are each driven by an electric motor. The substrate transport robot CR5 transports the substrate W from a substrate placement portion PS1 (described later) to the carrier C placed on the shelf 114.

The single-wafer transport region R9 includes a shuttle mechanism 112. The shuttle mechanism 112 is provided between the two substrate transport robots CR4 and CR5. The shuttle mechanism 112 includes the substrate placement portion PS1, a guide rail 121, and an electric motor (not illustrated).

The substrate placement portion PS1 is configured such that a plurality of substrates W are placed thereon. Therefore, the substrate placement portion PS1 includes a plurality of placement plates (not illustrated) disposed in the vertical direction Z. Note that the substrate placement portion PS1 may be configured such that only one substrate W is placed thereon. The guide rail 121 extends in the front-rear direction X. One end of the guide rail 121 extends to the delivery region R8. The substrate placement portion PS1 is movable along the guide rail 121.

The shuttle mechanism 112 moves the substrate placement portion PS1 between an intermediate position P11, a treatment side position P12, and a storage side position P13 by using the electric motor. The intermediate position P11 is a position where the substrate transport robot CR6 that will be described later can access the substrate placement portion PS1. The treatment side position P12 is a position where the substrate transport robot CR4 can access the substrate placement portion PS1. The storage side position P13 is a position where the substrate transport robot CR5 can access the substrate placement portion PS1.

The first single-wafer treatment region R10 does not include the substrate transport robot CR1 illustrated in FIG. 1, but includes a front tower TW1 and a rear tower TW2. Each of the front tower TW1 and the rear tower TW2 does not include the second single-wafer treatment chamber SW2, but includes three first single-wafer treatment chambers SW1 stacked in the vertical direction Z.

The second single-wafer treatment region R11 does not include the substrate transport robot CR2 illustrated in FIG. 1, but includes the front tower TW1 and the rear tower TW2. Each of the front tower TW1 and the rear tower TW2 does not include the second single-wafer treatment chamber SW2, but includes three first single-wafer treatment chambers SW1 stacked in the vertical direction Z. Each of the twelve first single-wafer treatment chambers SW1 of the two single-wafer treatment regions R10 and R11 performs treatment on one substrate W with, for example, pure water and IPA, and then performs spin drying.

The second single-wafer treatment region R11 includes a substrate transport robot CR6 provided between the relay region R6 and the front tower TW1. The substrate transport robot CR6 is configured similarly to the substrate transport robot CR1. The substrate transport robot CR6 includes, for example, a movable hand 91. The substrate transport robot CR6 transports one substrate W from the belt conveyor 83 to the substrate placement portion PS1.

The substrate transport robot CR4 is disposed to be surrounded by two front towers TW1 and two rear towers TW2. Similarly to the substrate transport robot CR1, the substrate transport robot CR4 includes, for example, two hands 91, an advance/retract portion 92, and an elevation rotation portion 93. The substrate transport robot CR4 transports one substrate W between the twelve first single-wafer treatment chambers SW1 and the substrate placement portion PS1.

An operation of the single-wafer treatment device 7 of the present embodiment will be briefly described. The belt conveyor 83 of the relay substrate transport mechanism 81 transports one substrate W in a horizontal posture to a position above the pin lifting/lowering unit 87. Thereafter, the pin lifting/lowering unit 87 lifts the one substrate W. The lifted substrate W is in a horizontal posture, and its device surface is wet. The substrate transport robot CR6 of the second single-wafer treatment region R11 receives one substrate W lifted by the pin lifting/lowering unit 87. Thereafter, the substrate transport robot CR6 transports the received substrate W to the substrate placement portion PS1 moved to the intermediate position P11.

Thereafter, the shuttle mechanism 112 moves the substrate placement portion PS1 from the intermediate position P11 to the treatment side position P12. The substrate transport robot CR4 of the single-wafer transport region R9 takes out one substrate W in a horizontal posture from the substrate placement portion PS1 by using the first hand 91. Thereafter, the substrate transport robot CR4 transports the taken-out substrate W to any one of the twelve first single-wafer treatment chambers SW1.

Each first single-wafer treatment chamber SW1 performs treatment on one substrate W in a horizontal posture with pure water and IPA, and then performs spin drying to dry the one substrate W. Thereafter, the substrate transport robot CR4 uses the second hand 91 to receive one dried substrate W from the first single-wafer treatment chamber SW1 that has performed the single-wafer treatment, and transports the received substrate W to the substrate placement portion PS1.

Thereafter, the shuttle mechanism 112 moves the substrate placement portion PS1 from the treatment side position P12 to the storage side position P13. The substrate transport robot CR5 of the indexer region 113 transports the one dried substrate W from the substrate placement portion PS1 to the carrier C placed on the shelf 114. When, for example, twenty-five substrates W are stored in the carrier C, the external transport mechanism (not illustrated) transports the carrier C storing the substrates W after the treatment from the shelf 114 to the next destination along the transport path RT.

According to the present embodiment, even in a case where the stocker device 2 illustrated in FIG. 12 is different from the stocker device 2 illustrated in FIG. 1, the substrate treatment system 1 of the present embodiment has the same effect as that of the first embodiment.

In FIG. 12, the shuttle mechanism 112 and the three substrate transport robots CR4, CR5, and CR6 transport one substrate W between the belt conveyor 83 (relay substrate transport mechanism 81), the twelve first single-wafer treatment chambers SW1, and the carrier C placed on the shelf 114. In this respect, at least one substrate transport robot (for example, the substrate transport robot CR3 illustrated in FIG. 1) may transport one substrate W between the belt conveyor 83, the twelve first single-wafer treatment chambers SW1, and the carrier C placed on the shelf 114. The shuttle mechanism 112 and the three substrate transport robots CR4, CR5, and CR6 each correspond to a horizontal substrate transport robot of the present invention. Further, a part of the configuration of the second embodiment may be applied to the substrate treatment system 1 of the first embodiment.

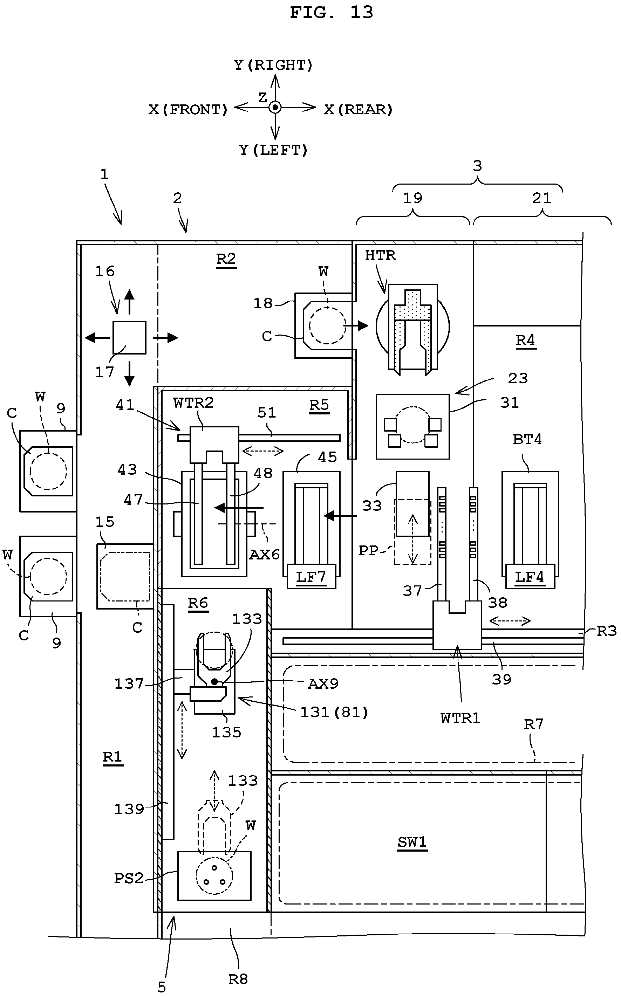

The present invention is not limited to the above embodiment, and can be modified as follows.
(1) In each of the embodiments described above, the relay substrate transport mechanism 81 includes the belt conveyor 83. In this regard, the relay substrate transport mechanism 81 may include a substrate transport robot 131 and a substrate placement portion PS2 illustrated in FIG. 13. The substrate transport robot 131 includes a relay hand 133, an advance/retract portion 135, a rotation portion 137, and a horizontal movement portion 139.

The relay hand 133 holds one substrate W in a horizontal posture and is movable. The advance/retract portion 135 advances and retracts the relay hand 133. The rotation portion 137 rotates the relay hand 133 and the advance/retract portion 135 about a vertical axis AX9 set in the rotation portion 137. The horizontal movement portion 139 moves the relay hand 133, the advance/retract portion 135, and the rotation portion 137 in the width direction Y. The advance/retract portion 135, the rotation portion 137, and the horizontal movement portion 139 are each driven by an electric motor. One or a plurality of substrates W can be placed on the substrate placement portion PS2.

The substrate placement portion PS2 is provided between the substrate transport robot 131 and the delivery region R8. That is, the substrate placement portion PS2 is provided on the left side of the substrate transport robot 131. In this modification example, the horizontal pushing mechanism 75 illustrated in FIG. 7B does not need to be provided.

An operation of the present modification example will be described. The underwater posture turning unit 43 turns, for example, twenty-five substrates W1 (first substrate group) from a vertical posture to a horizontal posture. Thereafter, the substrate transport robot 131 causes the relay hand 133 to enter the inside of the in-tank carrier 67 partially pulled up from the pure water in the posture turning tank 69, thereby taking out one substrate W1 from the in-tank carrier 67 of the underwater posture turning unit 43 by using the relay hand 133.

Thereafter, the rotation portion 137 rotates the relay hand 133 about the vertical axis AX9 to change an orientation of the relay hand 133 from the in-tank carrier 67 (underwater posture turning unit 43) to the substrate placement portion PS2. The substrate transport robot 131 causes the relay hand 133 directed to the substrate placement portion PS2 to enter the substrate placement portion PS2, thereby transporting the taken-out one substrate W1 to the substrate placement portion PS2. Thereafter, the substrate transport robot CR3 takes out the substrate W from the substrate placement portion PS2 and transports the substrate W to one of the two first single-wafer treatment chambers SW1 of the two front towers TW1.

(2) In each of the above-described embodiments, the second posture turning mechanism 41 includes the underwater posture turning unit 43, the standby tank 45, and the second batch transport mechanism WTR2. In this regard, the second posture turning mechanism 41 may include an articulated robot (posture turning unit) and the standby tank 45. In this case, the articulated robot includes a movable hand that holds one substrate W. The articulated robot takes out one substrate W in a vertical posture from the lifter LF7 of the standby tank 45 by using the hand, and turns the taken-out one substrate W into a horizontal posture. Thereafter, the articulated robot may transport the one substrate W in a horizontal posture to the relay substrate transport mechanism 81. The articulated robot may include a plurality of hands.

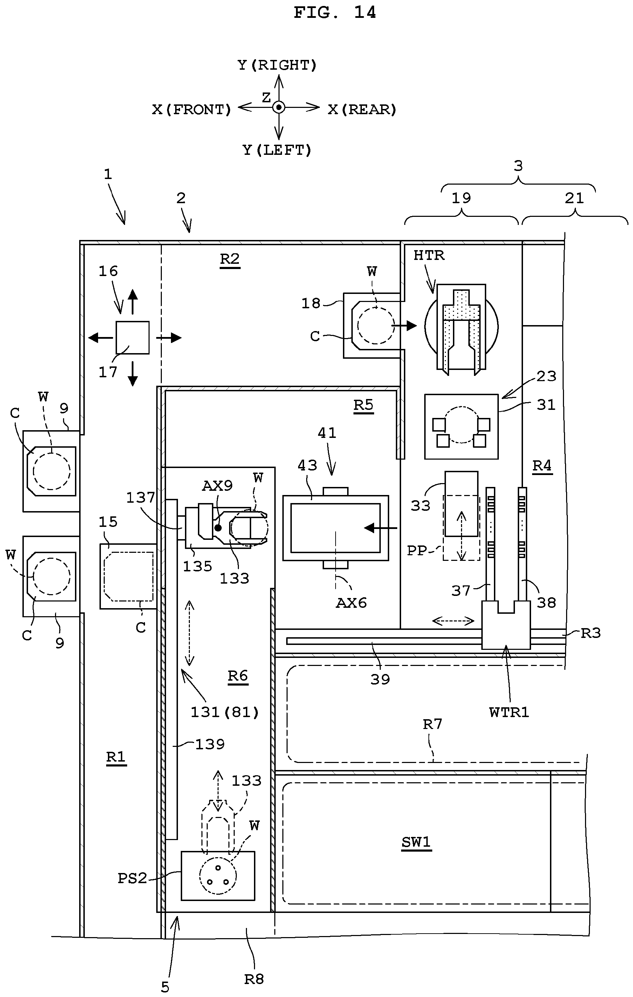

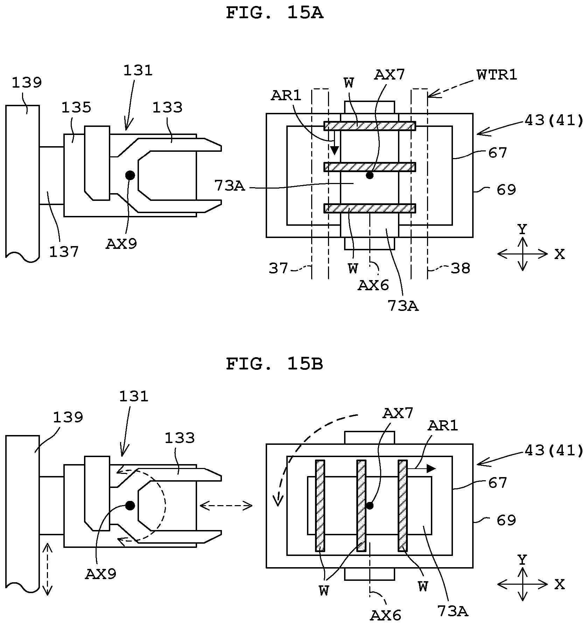

(3) In each of the above-described embodiments, the second posture turning mechanism 41 includes the standby tank 45, but may not include the standby tank 45 (see FIG. 14). In this case, the batch transport mechanism WTR1 directly transports the twenty-five substrates W subjected to treatment in the batch treatment device 3 to the underwater posture turning unit 43. As illustrated in FIG. 15A, the pusher 73A of the underwater posture turning unit 43 receives the twenty-five substrates W aligned in the width direction Y from the batch transport mechanism WTR1 in a vertical posture.

The pusher mechanism 73 of the underwater posture turning unit 43 rotates the pusher 73A holding the twenty-five substrates W by 90 degrees about the vertical axis AX7. As a result, the pusher mechanism 73 aligns the twenty-five substrates W in the front-rear direction X as illustrated in FIG. 15B. Thereafter, the underwater posture turning unit 43 rotates the twenty-five substrates W about the horizontal axis AX6 extending in the width direction Y to bring the twenty-five substrates W into a horizontal posture (see FIG. 6C).

As illustrated in FIGS. 14, 15A, and 15B, for example, the substrate transport robot 131 of the relay substrate transport mechanism 81 uses the relay hand 133 to receive one substrate W from the underwater posture turning unit 43 and transport the one substrate W to the substrate placement portion PS2 on the interface device 5 side. The relay substrate transport mechanism 81 may be the belt conveyor 83.

(4) In each of the above-described embodiments, the posture turning unit (second posture turning unit) included in the second posture turning mechanism 41 may be configured as follows. That is, the posture turning unit includes a substrate accommodating portion (for example, the in-tank carrier 67) that accommodates a plurality of substrates. The substrate accommodating portion is rotatable about the horizontal axis AX6 parallel to each of the device surfaces of the plurality of substrates W. The horizontal axis AX6 extends to the rear side, in the front-rear direction X, or in the width direction Y.

(5) In each of the above-described embodiments and modification examples, the transfer block 19 includes the substrate handling mechanism HTR, the posture turning unit 31, and the pusher 33A. In this regard, the transfer block 19 may include the substrate handling mechanism HTR and the pusher 33A without including the posture turning unit 31. That is, the substrate handling mechanism HTR may include the posture turning unit 31 (the function of the posture turning unit 31).

In this case, the substrate handling mechanism HTR is configured by an articulated robot. The articulated robot takes out a plurality of (for example, five) substrates W from the carrier, and turns the plurality of substrates W from a horizontal posture to a vertical posture. The articulated robot arranges the plurality of substrates W in the vertical posture on the pusher 33A.

(6) In the first embodiment and each modification example described above, each of the two single-wafer treatment regions R10 and R11 includes the six single-wafer treatment chambers (the first single-wafer treatment chamber SW1 and the second single-wafer treatment chambers SW2). In this regard, each of the two single-wafer treatment regions R10 and R11 may include six first single-wafer treatment chambers SW1 without including the second single-wafer treatment chamber SW2. In this case, each of the six first single-wafer treatment chambers SW1 may perform treatment on one substrate W with pure water and IPA, and then perform spin drying. In addition, in the case of this modification example, the two substrate transport robots CR1 and CR2 do not need to be provided.

(7) In the first embodiment and each modification example described above, the substrate transport robot CR3 transports one substrate W in a horizontal posture between the relay substrate transport mechanism 81, the twelve single-wafer treatment chambers (the first single-wafer treatment chamber SW1 and the second single-wafer treatment chambers SW2), and the carrier C placed on the shelf 89. This substrate transport may be shared by a plurality of substrate transport robots. One substrate W may be directly delivered between the two substrate transport robots. Further, one substrate W may be delivered via the substrate placement portion.

(8) In each of the above-described embodiments and modification examples, in at least one of the six substrate transport robots CR1 to CR6, the hand 91 may be moved by an articulated arm.

(9) In each of the above-described embodiments and modification examples, for example, in the batch treatment tank BT1, the fifty substrates W in which the twenty-five substrates W1 and the twenty-five substrates W2 are alternately disposed one by one are collectively immersed. The fifty substrates W (W1, W2) are aligned at a half pitch (for example, 5 mm). In this regard, in the batch treatment tank BT1, the twenty-five substrates W aligned at a full pitch (for example, 10 mm) may be collectively immersed.

(10) In each of the embodiments and the modification examples described above, for example, in the batch treatment tank BT1, the fifty substrates W as a treatment substrate group are collectively immersed. In the fifty substrates W (W1, W2), when each of the device surfaces of the twenty-five substrates W1 of the first substrate group faces rightward, each of the device surfaces of the twenty-five substrates W2 of the second substrate group may face leftward. In addition, when each of the device surfaces of the twenty-five substrates W1 of the first substrate group faces rightward, each of the device surfaces of the twenty-five substrates W2 of the second substrate group may face rightward.

## Claims

1. A substrate treatment system comprising:
a batch treatment device that collectively performs treatment on a plurality of substrates;
a single-wafer treatment device that performs treatment on the plurality of substrates one by one; and
an interface device that connects the batch treatment device and the single-wafer treatment device, wherein
the batch treatment device extends in a first horizontal direction,
the single-wafer treatment device is disposed to face the batch treatment device such that the single-wafer treatment device is aligned in a second horizontal direction orthogonal to the first horizontal direction,
the interface device is disposed to be adjacent to one end side of each of the batch treatment device and the single-wafer treatment device and to extend in the second horizontal direction,
the batch treatment device includes
a first carrier placement shelf on which a carrier for storing the plurality of substrates at a predetermined interval in a horizontal posture is placed,
a transfer block that is adjacent to the first carrier placement shelf,
a batch treatment block that is adjacent to the transfer block and extends in the first horizontal direction, and
a batch substrate transport region that is disposed adjacent to the transfer block and the batch treatment block on a side where the single-wafer treatment device is disposed and that has one end side extending to the interface device and the other end side extending in the first horizontal direction,
the transfer block includes a substrate handling mechanism and a first posture turning mechanism,
the substrate handling mechanism is configured to take out the plurality of substrates in a horizontal posture from the carrier placed on the first carrier placement shelf,
the first posture turning mechanism includes
a first posture turning unit that turns the plurality of substrates received from the substrate handling mechanism from a horizontal posture to a vertical posture, and
a vertical holder that holds the plurality of substrates turned into the vertical posture by the first posture turning unit,
the batch treatment block includes a plurality of batch treatment tanks arranged side by side in the first horizontal direction, each of the plurality of batch treatment tanks storing a treatment solution for immersing the plurality of substrates,
the batch substrate transport region includes a first batch transport mechanism that transports the plurality of substrates in a vertical posture between the plurality of batch treatment tanks, the vertical holder, and the interface device,
the interface device includes a posture turning region that is disposed on an opposite side to the batch treatment block via the transfer block and a relay region that is adjacent to the posture turning region and extends in the second horizontal direction,
the posture turning region includes a second posture turning mechanism that turns the plurality of substrates subjected to treatment in the batch treatment device from a vertical posture to a horizontal posture,
the relay region includes a relay substrate transport mechanism that transports the plurality of substrates turned into the horizontal posture by the second posture turning mechanism to the single-wafer treatment device,
the single-wafer treatment device includes
a second carrier placement shelf on which the carrier is placed, and
a single-wafer treatment block that is adjacent to the second carrier placement shelf,
the single-wafer treatment block includes
a plurality of single-wafer treatment chambers that perform predetermined treatment on the plurality of substrates subjected to treatment in the batch treatment device one by one, and
a horizontal substrate transport robot that receives the substrate transported by the relay substrate transport mechanism and transports the received substrate to one of the plurality of single-wafer treatment chambers, and
the horizontal substrate transport robot is configured to store the substrate subjected to treatment in one of the plurality of single-wafer treatment chambers in the carrier placed on the second carrier placement shelf.

2. The substrate treatment system according to claim 1, wherein
the second posture turning mechanism includes
a second posture turning unit that turns the plurality of substrates from a vertical posture to a horizontal posture, and
a standby tank that is provided between the transfer block and the second posture turning unit and stores an immersion liquid in which the plurality of substrates are immersed in the vertical posture.

3. The substrate treatment system according to claim 2, wherein
the second posture turning mechanism further includes a second batch transport mechanism,
the second batch transport mechanism includes a guide rail provided on an opposite side to the batch substrate transport region via the standby tank,
the second batch transport mechanism transports the plurality of substrates from the standby tank to the second posture turning unit in a vertical posture along the guide rail, and
the first batch transport mechanism transports the plurality of substrates in the vertical posture between the plurality of batch treatment tanks, the vertical holder, and the standby tank.

4. The substrate treatment system according to claim 3, wherein
the second batch transport mechanism includes a pair of chucks in which a plurality of pairs of holding grooves and a plurality of pairs of passage grooves are alternately disposed, and
in a case where a treatment substrate group in which the plurality of substrates and another plurality of substrates are alternately disposed is immersed in the immersion liquid in the standby tank, the second batch transport mechanism takes out the plurality of substrates from the treatment substrate group by using the pair of chucks and transports the plurality of taken-out substrates to the second posture turning unit.

5. The substrate treatment system according to any one of claims 1 to 4, further comprising:
a stocker device that is adjacent to the batch treatment device and the interface device, wherein
the stocker device includes
a load port that loads and unloads the carrier, and
a carrier transport robot that transports the carrier between at least the load port and the first carrier placement shelf.

6. The substrate treatment system according to any one of claims 1 to 4, wherein
the relay substrate transport mechanism includes a belt conveyor.

7. The substrate treatment system according to any one of claims 1 to 4, wherein
the relay substrate transport mechanism includes a movable relay hand that holds one substrate.

8. The substrate treatment system according to any one of claims 1 to 4, wherein
the substrate handling mechanism includes a plurality of hands that respectively hold the plurality of substrates and are integrally movable.
